(19) Europäisches Patentamt
European Patent Office
Office européen des brevets

(11) Publication number : **0 360 618 B1**

# (12) EUROPEAN PATENT SPECIFICATION

(45) Date of publication of patent specification : **16.12.92 Bulletin 92/51**

(51) Int. Cl.$^5$ : **G03F 7/075**

(21) Application number : **89309674.3**

(22) Date of filing : **22.09.89**

## (54) Light-sensitive composition.

(30) Priority : **22.09.88 JP 237984/88**

(43) Date of publication of application : **28.03.90 Bulletin 90/13**

(45) Publication of the grant of the patent : **16.12.92 Bulletin 92/51**

(84) Designated Contracting States : **DE GB**

(56) References cited :
EP-A- 0 231 497
US-A- 4 689 289
US-A- 4 722 881

(73) Proprietor : **FUJI PHOTO FILM CO., LTD.**
**210 Nakanuma Minami Ashigara-shi**
**Kanagawa 250-01 (JP)**

(72) Inventor : **Umehara, Akira c/o Fuji Photo Film Co. Ltd.**
**4000, Kawashiri, Yoshida-cho**
**Haibara-gun Shizuoka-ken (JP)**
Inventor : **Aoai, Toshiaki c/o Fuji Photo Film Co. Ltd.**
**4000, Kawashiri, Yoshida-cho**
**Haibara-gun Shizuoka-ken (JP)**
Inventor : **Aotani, Yoshimasa c/o Fuji Photo Film Co. Ltd.**
**4000, Kawashiri, Yoshida-cho**
**Haibara-gun Shizuoka-ken (JP)**
Inventor : **Sugimoto, Michiko c/o Fuji Photo Film Co. Ltd.**
**4000, Kawashiri, Yoshida-cho**
**Haibara-gun Shizuoka-ken (JP)**

(74) Representative : **Blake, John Henry Francis et al**
**BROOKES AND MARTIN High Holborn House**
**52/54 High Holborn**
**London WC1V 6SE (GB)**

EP 0 360 618 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a positive working light-sensitive composition which makes it possible to form a presensitized plate for use in making a lithographic printing plate (hereunder referred to as "PS plate"), proof sheets for process printing, figures for overhead projectors or fine resist patterns required for making integrated circuits (IC) of semiconductor elements.

As so-called positive working light-sensitive materials which are made soluble by irradiating with actinic rays, for instance, in making lithographic printing plates, there have been known o-quinonediazide compounds and these compounds have practically been utilized widely for preparing PS plates or the like. Such o-quinonediazide compounds are disclosed in various publications inclusive of U.S. Patent Nos. 2,766,118; 2,767,092; 2,772,972; 2,869,112; 2,907,665; 3,046,110; 3,046,111; 3,046,115; 3,046,118; 3,046,119; 3,046,120; 3,046,121; 3,046,122; 3,046,123; 3,061,430; 3,102,809; 3,106,465; 3,635,709; and 3,647,443.

These o-quinonediazide compounds are decomposed by irradiation with actinic rays to form 5-membered carboxylic acids and they are thus made alkali-soluble. In these applications of the light-sensitive material, such properties of the compounds are utilised. However, their light-sensitivity is insufficient. This problem arises because it is difficult to optically sensitize the o-quinonediazide compounds and their quantum yield never exceeds 1. Moreover, the wave length used for exposing the same is limited to a specific one and, therefore, tolerance with respect to light sources is narrow. In other words, it is difficult to impart resistance to incandescent rays to the composition. In addition, the absorption of light in Deep-UV region is great and thus it is not suitable for applications in which light of short wave length is used to enhance the resolution of a photoresist.

Many attempts have been made to improve the light-sensitivity of light-sensitive compositions containing o-quinonediazide compounds. However, it is very difficult to improve the light-sensitivity while maintaining the development latitude during development. For instance, examples of such attempts are those disclosed in Japanese Patent Publication for Opposition Purpose (hereunder referred to as "J.P. KOKOKU") No. Sho 48-12242, Japanese Patent Un-examined Publication (hereunder referred to as "J.P. KOKAI") No. Sho 52-40125 and U.S. Patent No. 4,307,173.

Recently, there have been proposed some positive working light-sensitive compositions free of o-quinonediazide compounds. One example thereof comprises a polymeric compound having o-nitrocarbinol ester groups as disclosed in J.P. KOKOKU No. Sho 56-2696. However, such a composition does not provide high sensitivity for the same reasons as those discussed above in connection with o-quinonediazide compounds.

On the other hand, as pattern-forming methods used in making electronic parts such as semiconductor elements, magnetic bubble memories and integrated circuits, there have been widely employed methods in which a photoresist sensitive to ultraviolet and visible rays. The photoresists can be divided into two groups, one of which is negative working type ones whose exposed portions are made insoluble in a developer by irradiating with light, and the other of which is positive working ones whose exposed portions are, on the contrary, made soluble in a developer. The negative working type ones are superior in sensitivity to the positive working ones and also excellent in adhesion to a substrate and resistance to chemicals required in wet etching. Therefore, the negative working ones were the mainstreams of photoresists. However, the line width and the distance between lines of patterns become smaller as the degree of integration of semiconductor elements and the packaging density thereof are increased. In addition, dry etching techniques have been adopted as a means for etching substrates. Thus, the photoresists should have high resolution and high resistance to dry etching. For this reason, positive working photoresists are mainly utilized recently. In particular, there have been exclusively used alkali developable positive working photoresists mainly composed of alkali-soluble novolak resins as disclosed in J.C. Strieter, Kodak Microelectronics Seminar Proceedings, 1976, p. 116, since they are excellent in sensitivity, resolution and resistance to dry etching.

However, it is required to further scale down the size of patterns to thus achieve higher packaging density and degree of integration accompanied by the recent increase in multifunctionality and high functionality of electronic devices.

More specifically, the size of integrated circuits in their transversal direction is greatly reduced, but the size thereof in the longitudinal direction cannot be reduced so much. Therefore, the ratio of the height of the resist patterns to the width thereof is correspondingly increased. For this reason, it becomes very difficult to restrict the change in size of the resist patterns on a semiconductor wafer having a complicated stepped structure as the scale down of patterns proceeds. In addition, various methods for exposure suffer from problems as the scale down in the minimum size of patterns. For instance, the exposure by means of light causes interference effect due to light reflected by the stepped portions of the substrate which greatly affects dimensional accuracy. On the other hand, in the exposure by means of an electron beam, the ratio of the height to the width of fine resist patterns cannot be increased because of the proximity effect caused due to backscattering of electrons.

It is found that most of these problems can be eliminated by the use of a multilayered resist system. The

multilayered resist system is summarized in Solid State Technology, 74 (1981) and a variety of investigations on the multilayered resist system have been reported. In general, the multilayered resist methods can be divided into triple layer resist method and double layer resist method. The triple layer resist method comprises applying an organic film for leveling onto the surface of a stepped substrate, and then applying thereto an inorganic intermediate layer and a resist layer in this order; patterning the resist layer, removing the inorganic layer by dry etching using the patterned resist layer as a mask, and finally patterning the organic leveling layer by $O_2$ RIE (reactive ion etching) technique to form a desired pattern on the stepped substrate. The investigation of this method has been started from earlier stage since it can essentially utilize techniques conventionally known, but it requires the use of very complicated processes, or since these layers, i.e., an organic film, an inorganic film and an organic film which differ in physical properties from each other are superposed, the intermediate layer is liable to cause cracks or to form pinholes. Contrary to the triple layer resist method, the double layer resist method utilizes a resist having properties of both resist and inorganic intermediate layers in the triple layer resist method, more specifically a resist resistant to oxygen plasma etching and thus the formation of cracks and pinholes can be suppressed. Further, since the number of layers are reduced from 3 to 2, the process can be simplified. However, a conventional resist can be used as the upper resist in the triple layer resist method while, in the double layer resist method, it is required to newly develop a resist excellent in resistance to oxygen plasma.

Under such circumstances, there has been required to develop a highly sensitive positive working photoresist having a high degree of resolution which is excellent in resistance to oxygen plasma and can hence be used as an upper resist in the double layer resist method or the like, in particular an alkaline developable resist which can be used without changing the processes currently employed. As such a resist, there have been proposed a light-sensitive composition comprising a combination of a conventional o-quinonediazide light-sensitive material and a silicone polymer such as polysiloxane or polysilmethylene which is made alkali-soluble, for instance, those disclosed in J.P. KOKAI Nos. Sho 61-256347, Sho 61-144639, Sho 62-159141, Sho 62-191849, Sho 62-220949; Sho 62-229136, Sho 63-90534 and Sho 63-91654 and U.S. Patent No. 4,722,881; and a light-sensitive composition comprising a combination of a polysiloxane/carbonate block copolymer and an effective amount of an onium salt as disclosed in J.P. KOKAI No. Sho 62-136638.

However, the production of these silicone polymers is very difficult, since they should be made alkali-soluble and so forth and their stability with time is not always sufficient.

US Patent No. 4,689,289 discloses the formation of positive resist images using compositions containing silicone-organic block copolymers with iodonium and sulfonium salts as acid generating compounds.

The inventors of this invention have conducted various studies to solve the foregoing problems, and have found that a combination of an organic polysiloxane compound inherently insoluble in an alkali and excellent in stability with time with a compound capable of generating an acid through irradiation with actinic rays or radiant rays can unexpectedly be made alkali-soluble by exposing it to light and thus have completed the present invention.

Consequently, the present invention provides a positive working light-sensitive composition comprising:

(a) a compound capable of generating an acid through irradiation with actinic rays or radiant rays, selected from formulae (XXI) to XXVII describes below; and

(b) an organic polysiloxane compound having a linear one-dimensional structure, a branched or ladder type two-dimensional structure and/or a three-dimensional network structure, derived from formulae (I) to (V) below.

The positive working light-sensitive composition of the present invention may further comprise an alkaline-soluble polymer.

The present invention will hereinafter be explained in more detail.

Organic Polysiloxane having Linear, Branched and/or Three-dimensional Structures

The polysiloxane compounds used in the composition of the present invention as the component (b) are prepared by hydrolyzing or alkoxylating a compound represented by the following general formula (I), (II), (III), (IV) or (V) or a combination thereof and then condensing the resultant product.

$$R_1 - Si - (X)_3 \qquad (I)$$

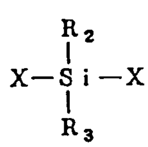

(II)

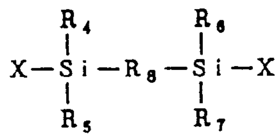

(III)

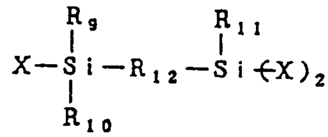

(IV)

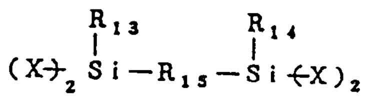

(V)

In the foregoing formulas, $R_1$ to $R_7$, $R_9$ to $R_{11}$, and $R_{13}$ to $R_{14}$ may be the same or different and each represents a hydrogen atom or an alkyl, substituted alkyl, aryl, substituted aryl, alkenyl, substituted alkenyl, silyl, substituted silyl, siloxy or substituted siloxy group.

More specifically, the alkyl group may be a linear, branched or cyclic one preferably having about 1 to about 10 carbon atoms and specific examples thereof include methyl, ethyl, propyl, butyl, hexyl, octyl, decyl, iso-propyl, iso-butyl, tert-butyl, 2-ethylhexyl and cyclohexyl groups. The substituted alkyl group may be those listed above which are substituted with a halogen atom such as chlorine atom, an alkoxy group having 1 to 6 carbon atoms such as methoxy group, an aryl group such as phenyl group and/or an aryloxy group such as phenoxy group and specific examples thereof are monochloromethyl, dichloromethyl, trichloromethyl, bromomethyl, 2-chloroethyl, 2-bromoethyl, 2-methoxyethyl, 2-ethoxyethyl, phenylmethyl, naphthylmethyl and phenoxymethyl groups.

The aryl group may preferably be monocyclic or bicyclic ones such as phenyl, α-naphthyl and ß-naphthyl groups. The substituted aryl groups may be those listed above which are substituted with alkyl groups having 1 to 6 carbon atoms such as methyl and ethyl groups; alkoxy groups having 1 to 6 carbon atoms such as methoxy and ethoxy groups; halogen atoms such as chlorine atom; and/or nitro, phenyl, carboxy, hydroxy, amido, imido and/or cyano groups. Specific examples thereof are 4-chlorophenyl, 2-chlorophenyl, 4-bromophenyl, 4-nitrophenyl, 4-hydroxyphenyl, 4-phenylphenyl, 4-methylphenyl, 2-methylphenyl, 4-ethylphenyl, 4-methoxyphenyl, 2-methoxyphenyl, 4-ethoxyphenyl, 2-carboxyphenyl, 4-cyanophenyl, 4-methyl-1-naphtyl, 4-chloro-1-naphthyl, 5-nitro-1-naphthyl, 5-hydroxy-1-naphthyl, chloro-2-naphthyl, 4-bromo-2-naphthyl and 5-hydroxy-2-naphthyl groups.

The alkenyl group is, for instance, a vinyl group and an allyl group and the substituted alkenyl group may be a vinyl group which is substituted with alkyl groups such as methyl group and/or aryl groups such as phenyl group. Specific examples of the substituted alkenyl groups are 1-methylvinyl, 2-methylvinyl, 1,2-dimethylvinyl, 2-phenylvinyl, 2-(p-methylphenyl)vinyl, 2-(p-methoxylphenyl)vinyl, 2-(p-chlorophenyl)vinyl and 2-(o-chlorophenyl)vinyl.

Examples of the substituted silyl groups are alkyl and/or aryl-substituted silyl groups such as trialkylsilyl and triarylsilyl groups. Such alkyl and aryl groups may be those listed above.

If these substituents each represents a siloxy or substituted siloxy group, these groups may be those bonded with siloxy or substituted siloxy groups of the adjacent structural units or those having a two-dimensional or three-dimensional structure such as those formed by bonding the siloxy or substituted siloxy group to that of other molecule as will be described below:

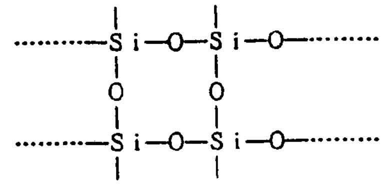

$R_8$, $R_{12}$ and $R_{15}$ may be the same or different and each represents a single bond, a bivalent alkylene group, a substituted alkylene group, an arylene group or a substituted arylene group. More specifically, the alkylene

group may be linear, branched or cyclic ones, particularly a linear alkylene group and preferably those having 1 to 10 carbon atoms such as methylene, ethylene, butylene and octylene groups. Examples of the substituted alkylene group are the foregoing alkylene groups which are substituted with halogen atoms such as chlorine atom, alkoxy groups having 1 to 6 carbon atoms and/or aryloxy groups having 6 to 10 carbon atoms.

The arylene group may preferably be monocyclic and bicyclic ones such as phenylene and naphthylene groups. Moreover, examples of the substituted arylene group are arylene groups which are substituted with alkyl groups having 1 to 6 carbon atoms such as methyl and ethyl groups, alkoxy groups having 1 to 6 carbon atoms such as methoxy and ethoxy groups and/or halogen atoms such as chlorine atom. Specific examples thereof are chlorophenylene, bromophenylene, nitrophenylene, phenylphenylene, methylphenylene, ethylphenylene, methoxyphenylene, ethoxyphenylene, cyanophenylene, methylnaphthylene, chloronaphthylene, bromonaphthylene and nitronaphthylene groups.

X represents a hydrolyzable group and specific examples thereof include halogen atoms such as chlorine and bromine atoms; alkoxy groups having 1 to 10 carbon atoms such as methoxy, ethoxy and propoxy groups; aryloxy groups having 6 to 10 carbon atoms such as phenoxy group; acyloxy groups having 1 to 10 carbon atoms such as acetoxy group; oxime groups having 1 to 6 carbon atoms such as methylaldoxime; amido, ureido and amino groups.

The polysiloxane compounds used in the present invention can specifically be represented by a structure composed of one or more repeating units selected from the group consisting of those represented by the following general formulas:

(VI)

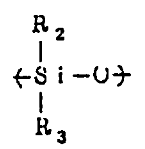

(VII)

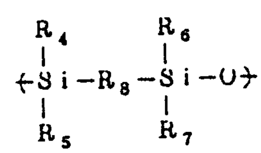

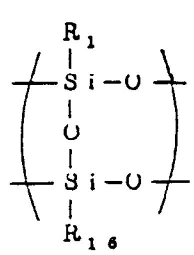

(VIII)

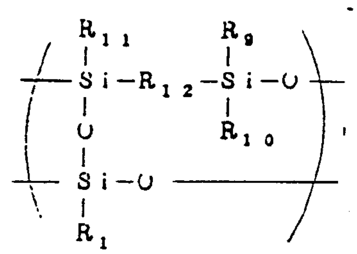

(IX)

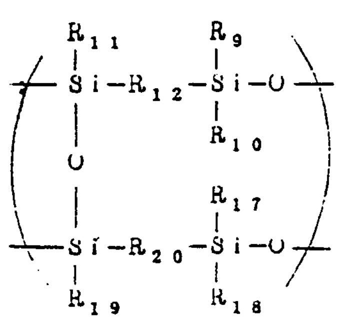

(X)

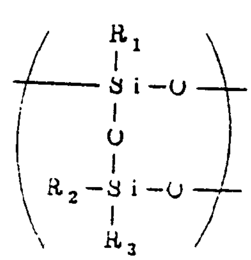

(XI)

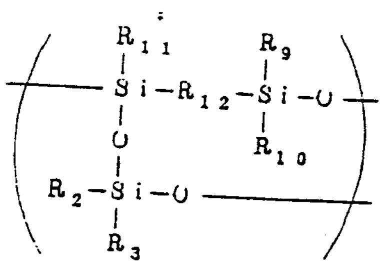

(XII)

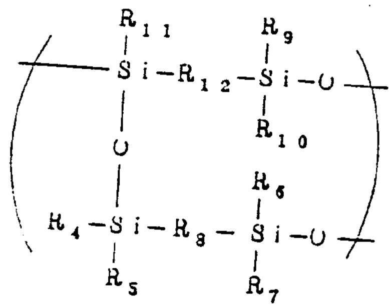

(XIII)

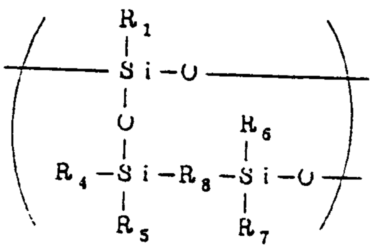

(XIV)

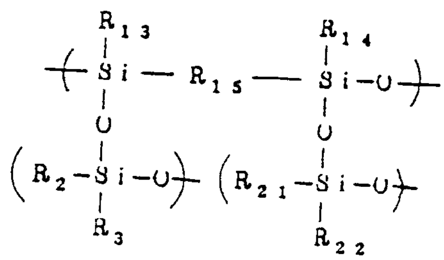

(XV)

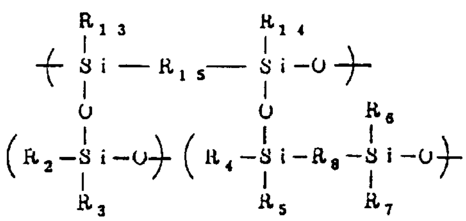

(XVI)

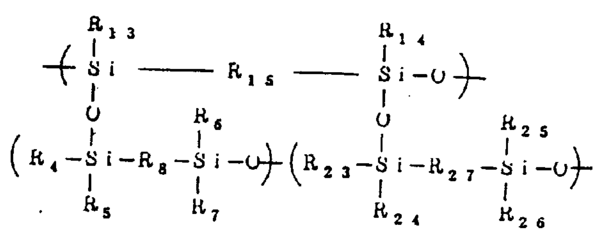

(XVII)

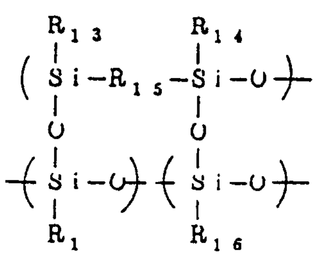

(XVIII)

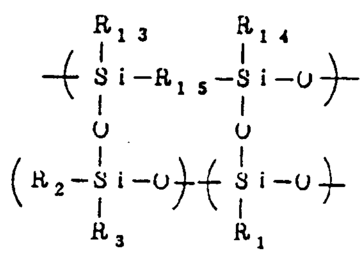

(XIX)

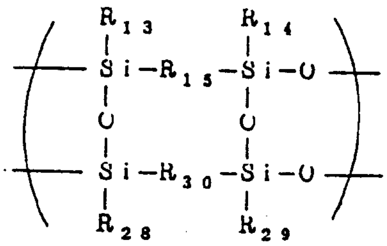

(XX)

In these formulas, $R_{16}$ to $R_{19}$, $R_{21}$ to $R_{26}$, and $R_{28}$ to $R_{29}$ may be the same or different and each has the same meanings as those defined above in connection with the groups $R_1$ to $R_7$, $R_9$ to $R_{11}$, $R_{13}$ to $R_{14}$ ; and $R_{20}$, $R_{27}$ , and $R_{30}$ may be the same or different and each has the same meanings as those defined above in connection with the groups $R_8$, $R_{12}$ and $R_{15}$.

Specific examples of the organic polysiloxane compounds as used herein are as follows:

(1)

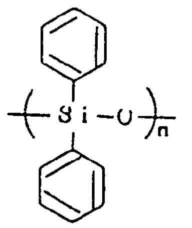

(2)

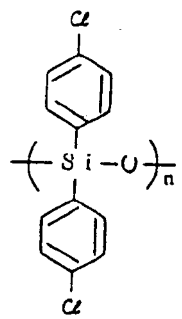

(3)

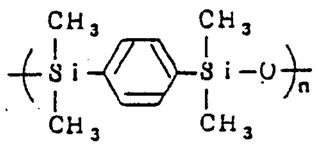

(4)

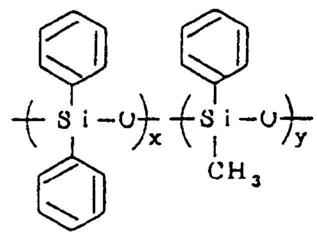

(5)

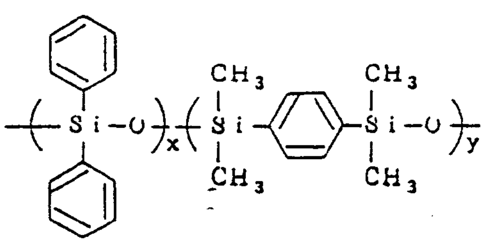

(6)

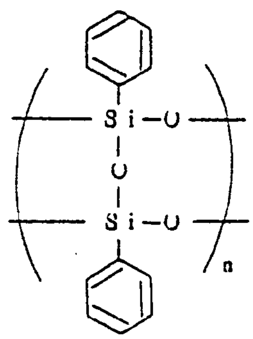

(7)

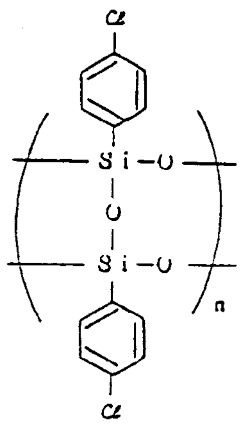

(8)

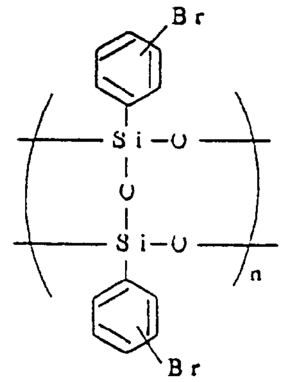

(9)

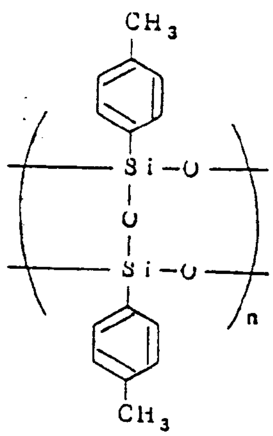

(10)

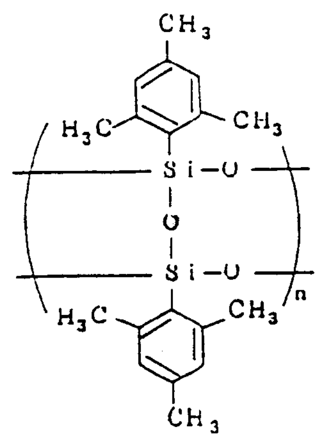

(11)

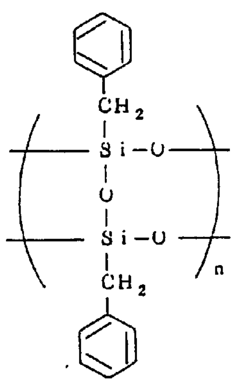

(12)

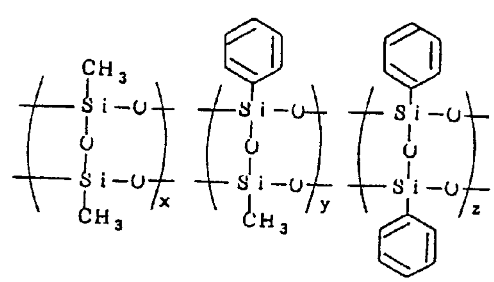

(13)

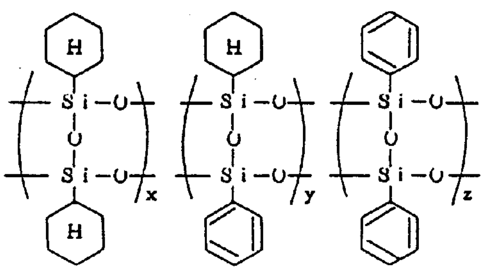

(14)

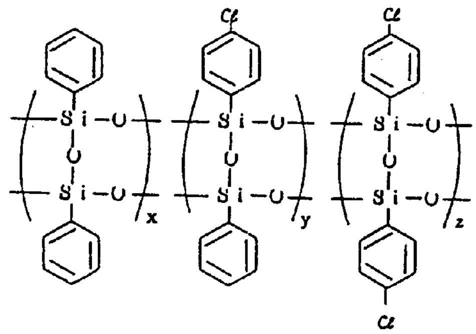

(15)

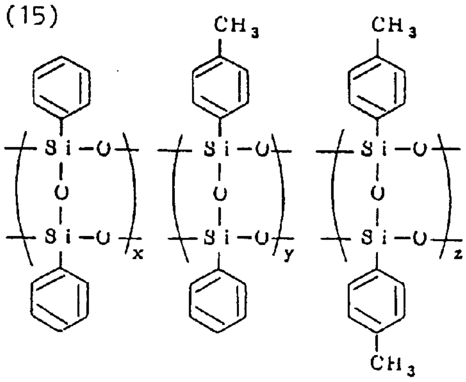

(16)

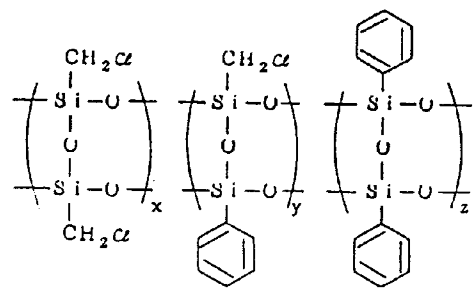

(17)

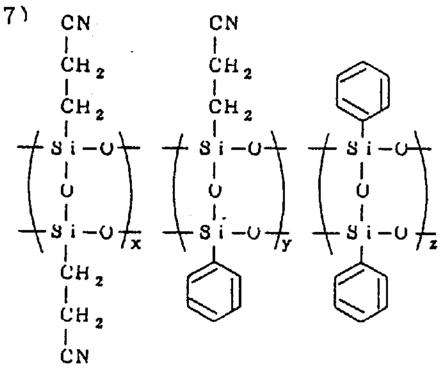

(18)

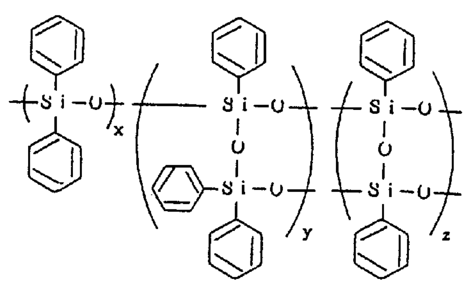

(19)

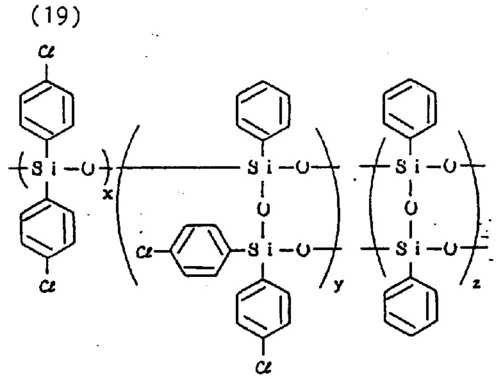

(20)

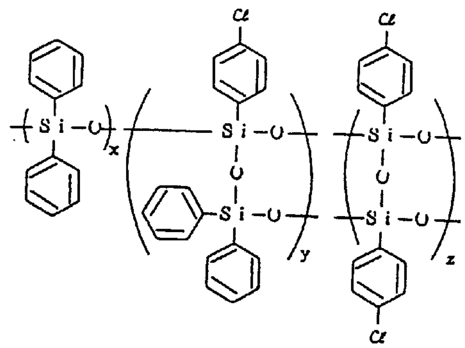

(21)

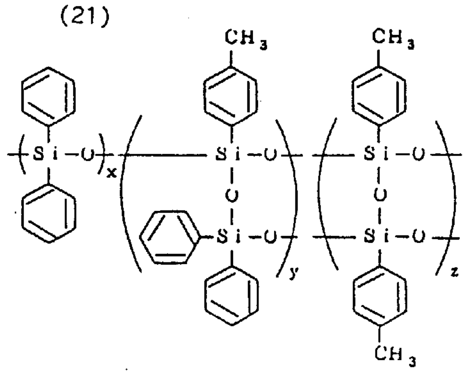

(22)

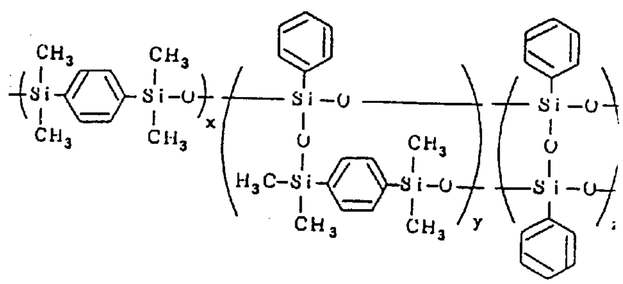

(23)

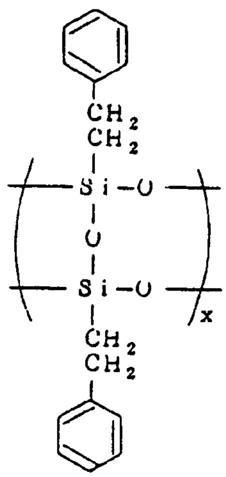

(24)

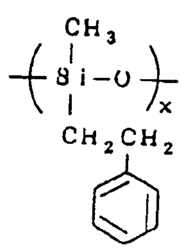

(25)

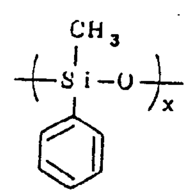

In the foregoing examples of the compound, n, x, y and z each is an integer of not less than 1.

The molecular weight of the organic polysiloxane used in the invention can freely be controlled by changing the condensation conditions, but preferred value thereof is not less than 500, more preferably 1,000 to 500,000 expressed in the weight averaged molecular weight.

<u>Compounds Capable of Generating Acids Through Irradiation of Actinic Rays or Radiant Rays</u>

Examples of suitable compounds capable of generating acids through irradiation with actinic rays or radiant

rays used in the invention as the component (a) are various known compounds and mixtures such as diazonium, phosphonium, sulfonium and iodonium salts of $BF_4^-$, $AsF_6^-$, $PF_6^-$, $SbF_6^-$, $SiF_6^-$ and $C\ell O_4^-$; organic halogen compounds; and combinations of organometals and organic halogen compounds. It is also suitably used, in the composition of the present invention, compounds capable of generating acids through photolysis as disclosed in U.S. Patent No. 3,779,778, German Patent No. 2,610,842 and European Patent No. 126,712. In addition, compounds which are combined with a suitable dye to give a visible contrast between exposed and unexposed areas when they are exposed to light can also be used in the composition of the invention. Examples of such compounds are disclosed in, for instance, J.P. KOKAI Nos. Sho 55-77742 and Sho 57-163234.

For use in the present invention, the compounds capable of generating acids are selected from the following groups (1) to (3).

(1) Oxadiazole derivatives or s-triazine derivatives represented by the following general formula (XXI) or (XXII) which is substituted with a trihalomethyl group:

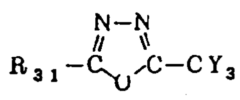

(XXI)

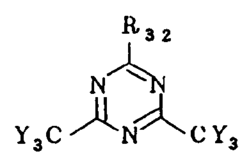

(XXII)

In the general formulas, $R_{31}$ represents a substituted or unsubstituted aryl or alkenyl group; $R_{32}$ represents $R_{31}$, $-CY_3$ or a substituted or unsubstituted alkyl group; and Y represents a halogen atom, in particular a chlorine or bromine atom, provided that three Y's may be the same or different.

Specific examples thereof are those listed below:

(XXI-1)

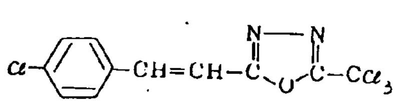

(XXI-2)

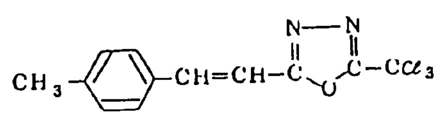

(XXI-3)

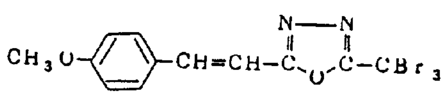

(XXI-4)

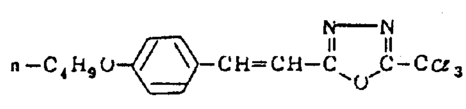

(XXI-5)

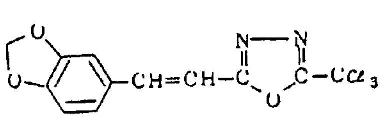

(XXI-6)

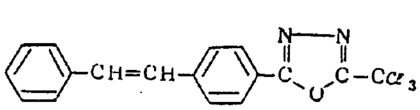

(XXI-7)

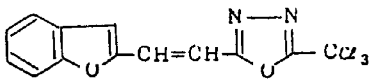

(XXI-8)

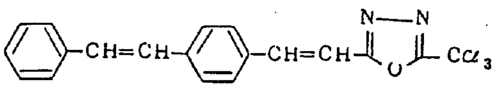

(XXII-1)

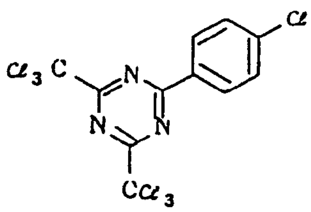

(XXII-2)

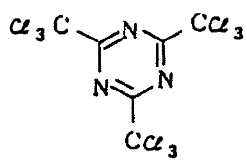

(XXII-3)

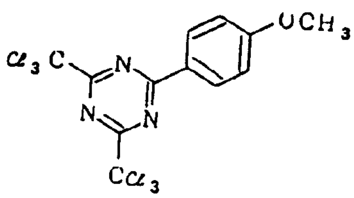

(XXII-4)

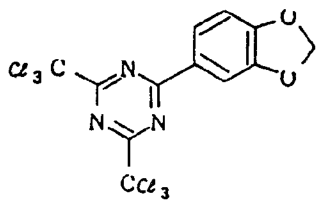

(XXII-5)

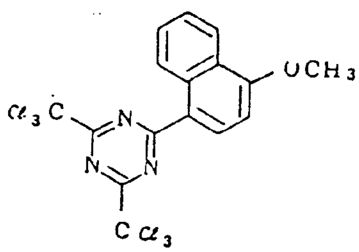

(XXII-6)

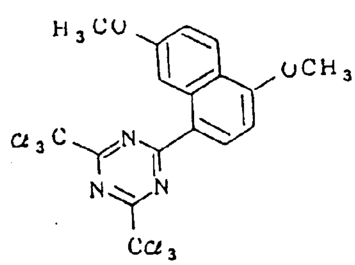

(XXII-7)

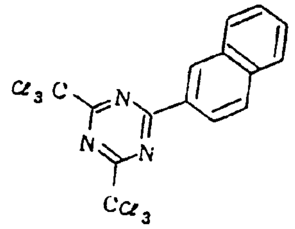

(XXII-8)

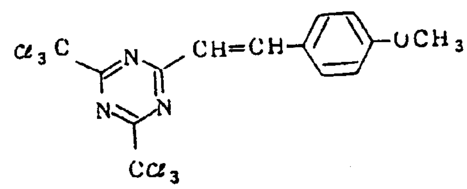

(XXII-9)

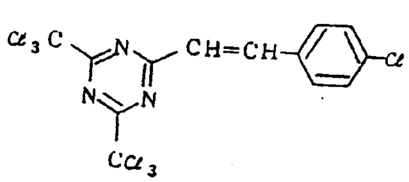

(XXII-10)

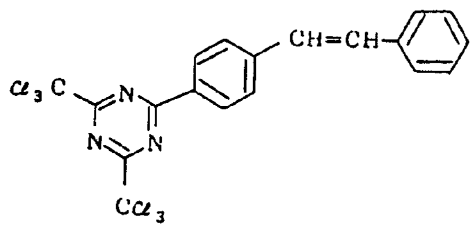

(2) Iodonium salts or sulfonium salts represented by the following general formula (XXIII) or (XXIV) respectively:

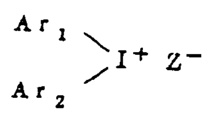

(XXIII)

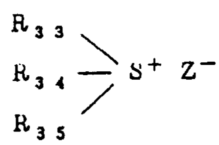

(XXIV)

In these formulas, $Ar_1$ and $Ar_2$ may be the same or different and each represents a substituted or unsubstituted aromatic group. Examples of preferred substituents of the aromatic groups are alkyl, haloalkyl, cycloalkyl, aryl, alkoxy, nitro, carbonyl, alkoxycarbonyl, hydroxy and mercapto groups and halogen atoms, more preferably alkyl groups having 1 to 8 carbon atoms, alkoxy groups having 1 to 8 carbon atoms, nitro group and chlorine atom. $R_{33}$, $R_{34}$ and $R_{35}$ may be the same or different and each represents a substituted or unsubstituted alkyl or aromatic group, preferably an aryl group having 6 to 14 carbon atoms, an alkyl group having 1 to 8 carbon atoms or a substituted derivative thereof. Examples of preferred substituents for the aryl groups are alkoxy groups having 1 to 8 carbon atoms, alkyl groups having 1 to 8 carbon atoms, nitro, carbonyl and hydroxyl groups and halogen atoms and those for alkyl groups are alkoxy groups having 1 to 8 carbon atoms, carbonyl group and alkoxycarbonyl groups. $Z^-$ represents $BF_4^-$, $PF_6^-$, $AsF_6^-$, $SbF_6^-$, $C\ell O_4^-$, $CF_3SO_3^-$. Moreover, two of the groups $R_{33}$, $R_{34}$ and $R_{35}$, and $Ar_1$ and $Ar_2$ each may be bonded through a single bond or a substituent.

Examples of the compounds represented by formula (XXIII) are those disclosed in J.P. KOKAI Nos. Sho 50-158680 and Sho 51-100716 and J.P. KOKOKU No. Sho 52-14277. Specific examples thereof are as follows:

(XXIII-1)

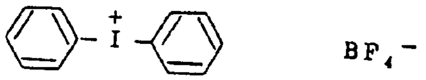

(XXIII-2)

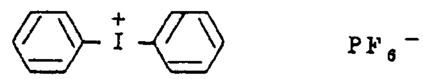

(XXIII-3)

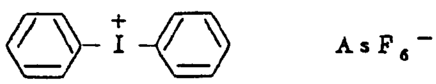

(XXIII-4)

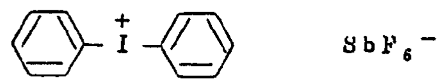

(XXIII-5)

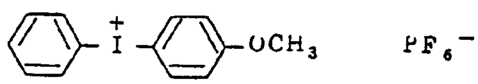

(XXIII-6)

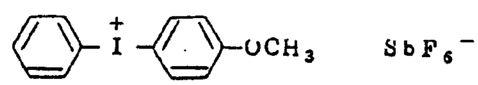

(XXIII-7)

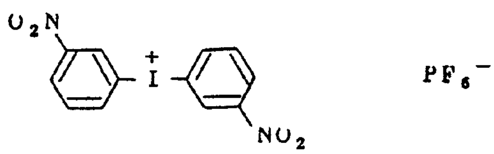

(XXIII-8)

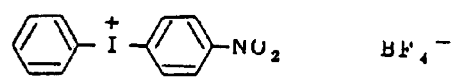

(XXIII-9)

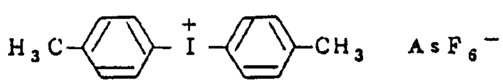

(XXIII-10)

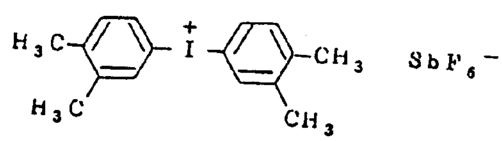

(XXIII-11)

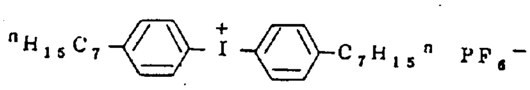

(XXIII-12)

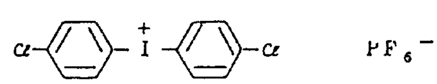

(XXIII-13)

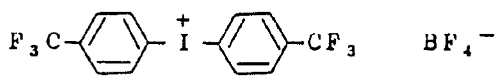

(XXIII-14)

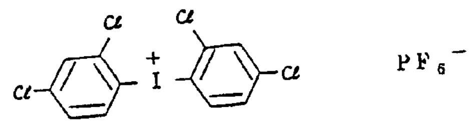

(XXIII-15)

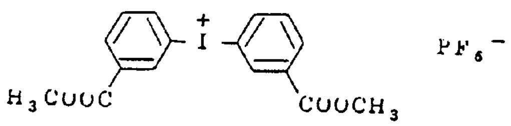

(XXIII-16)

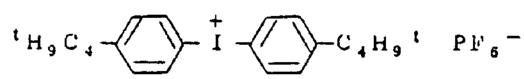

(XXIII-17)

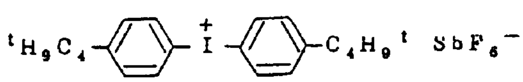

(XXIII-18)

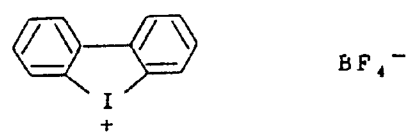

(XXIII-19)

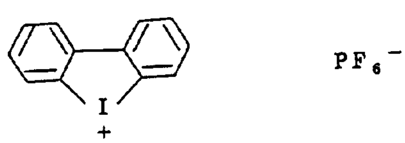

(XXIII-20)

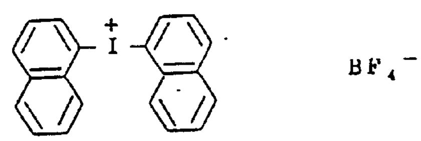

Examples of the compounds represented by formula (XXIV) are those disclosed in J.P. KOKAI No. Sho 51-56885, J.P. KOKOKU No. Sho 52-14278, U.S. Patent No. 4,442,197 and German Patent No. 2,904,626. Specific examples thereof are listed below:

(XXIV-1)

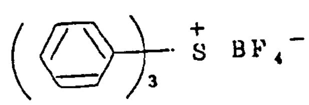

(XXIV-2)

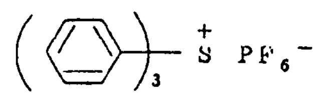

(XXIV-3)

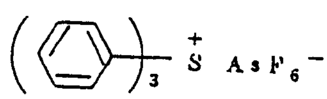

(XXIV-4)

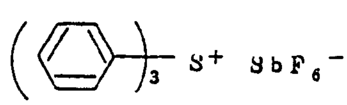

(XXIV-5)

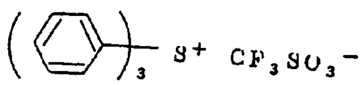

(XXIV-6)

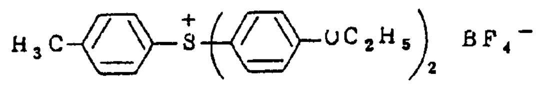

(XXIV-7)

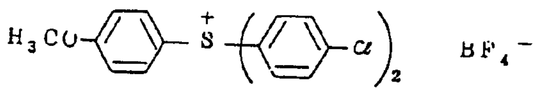

(XXIV-8)

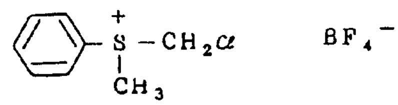

(XXIV-9)

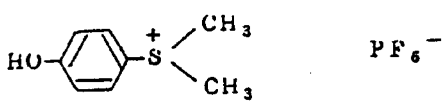

(XXIV-10)

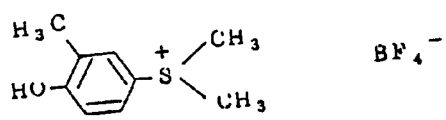

(XXIV-11)

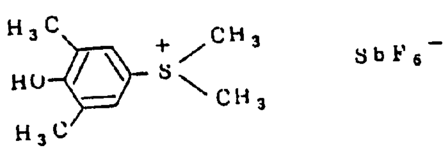

(XXIV-12)

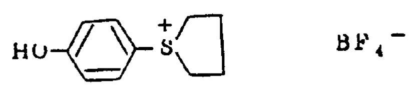

(XXIV-13)

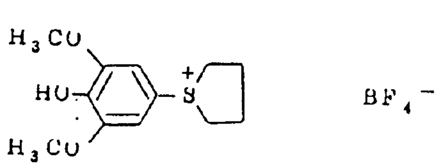

(XXIV-14)

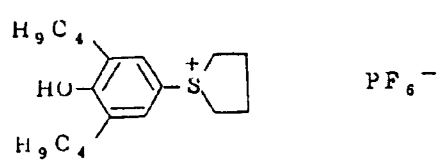

(XXIV-15)

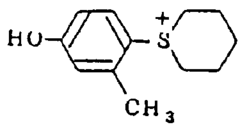

$BF_4^-$

(XXIV-16)

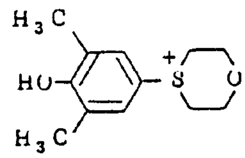

$PF_6^-$

(XXIV-17)

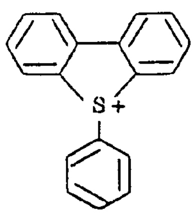

$BF_4^-$

(XXIV-18)

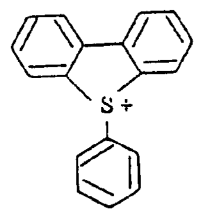

$PF_6^-$

(XXIV-19)

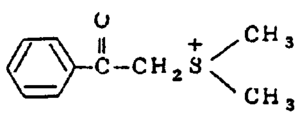

$SbF_6^-$

(XXIV-20)

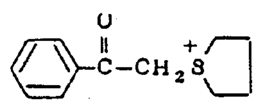

$BF_4^-$

(XXIV-21)

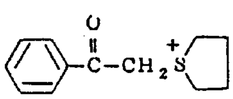

$AsF_6^-$

(XXIV-22)

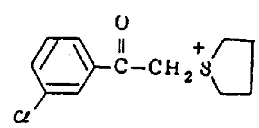

$AsF_6^-$

(XXIV-23)

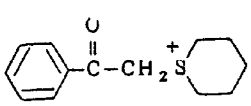

$PF_6^-$

(XXIV-24)

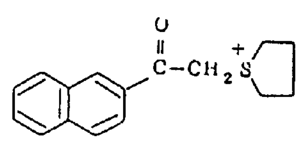

$BF_4^-$

(XXIV-25)

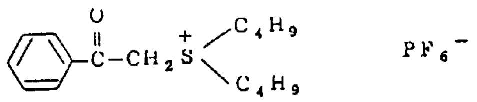

(XXIV-26)

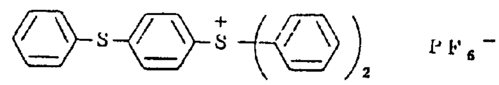

(XXIV-27)

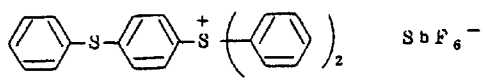

(XXIV-28)

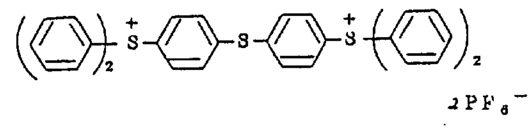

(XXIV-29)

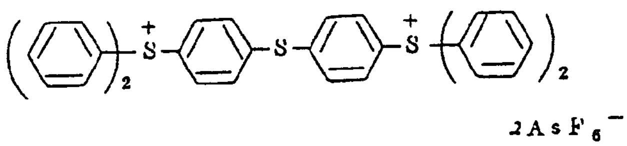

The compounds represented by the general formulas (XXIII) and (XXIV) are known and can be prepared, for instance, according to the procedures disclosed in J.W. Knapczyk et al., J. Am. Chem. Soc., 1969, 91, p. 145; A.L. Maycock et al., J. Org. Chem., 1970, 35, p. 2532; E. Goethals et al., Bull. Soc. Chem. Belg., 1964, 73, p. 546; H.M. Leicester, J. Am. Chem. Soc., 1929, 51, p. 3587; J. V. Crivello et al., J. Polym. Sci. Polym. Chem. Ed., 1980, 18, p. 2677; U.S. Patent Nos. 2,807,648 and 4,247,473; F.M. Beringer et al., J. Am. Chem. Soc., 1953, 75, p. 2705; and J.P. KOKAI No. Sho 53-101331.

(3) Disulfone derivatives or imidosulfonate derivatives represented by the following general formula (XXV) or (XXVI):

$$Ar_3\text{-}SO_2\text{-}SO_2\text{-}Ar_4 \qquad (XXV)$$

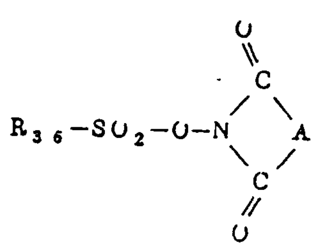

(XXVI)

In these formulas, $Ar_3$ and $Ar_4$ may be the same or different and each represents a substituted or unsubstituted aryl group; $R_{36}$ represents a substituted or unsubstituted alkyl or aryl group and A represents a substituted or unsubstituted alkylene, alkenylene or arylene group.

Specific examples thereof are as follows:

(XXV-1)

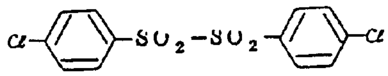

(XXV-2)

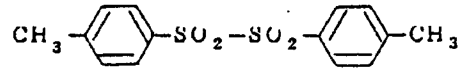

(XXV-3)

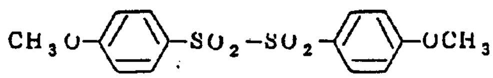

(XXV-4)

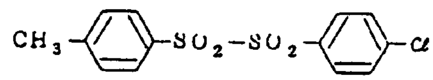

(XXV-5)

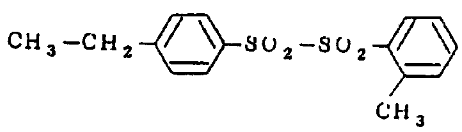

(XXV-6)

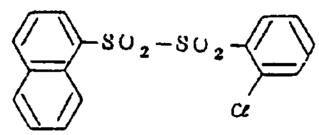

(XXV-7)

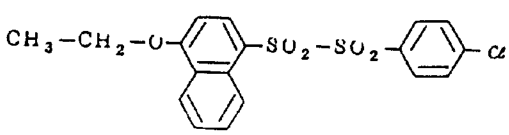

(XXV-8)

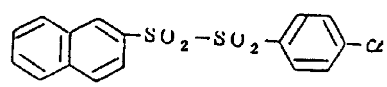

(XXV-9)

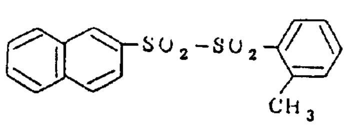

(XXV-10)

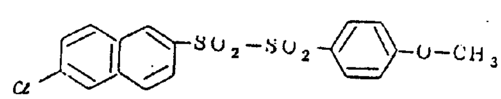

(XXVI-1)

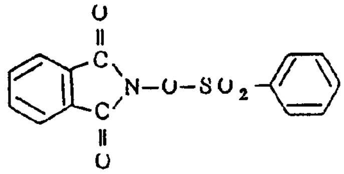

(XXVI-2)

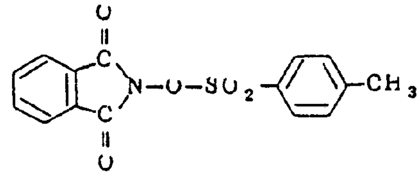

(XXVI-3)

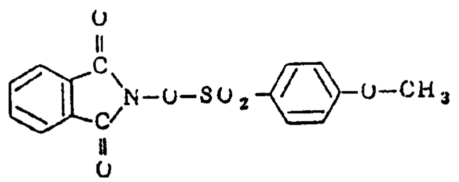

(XXVI-4)

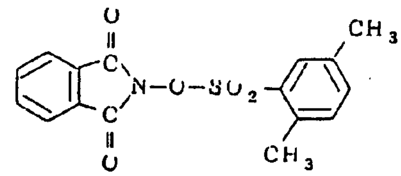

(XXVI-5)

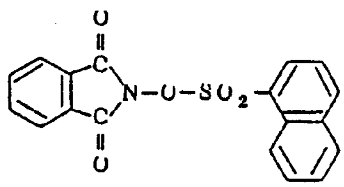

(XXVI-6)

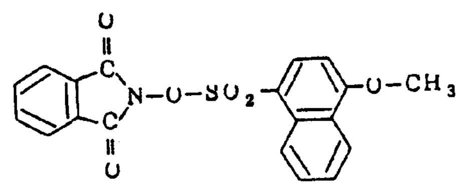

(XXVI-7)

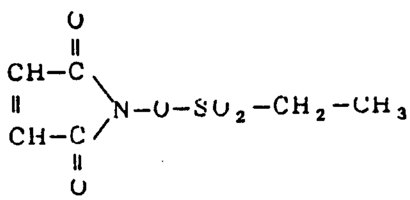

(XXVI-8)

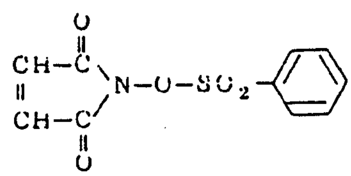

(XXVI-9)

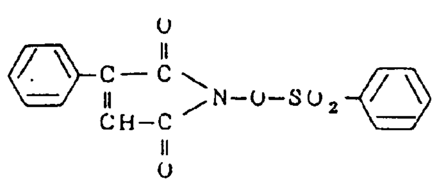

(XXVI-10)

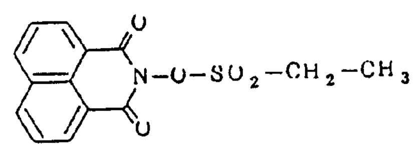

(XXVI-11)

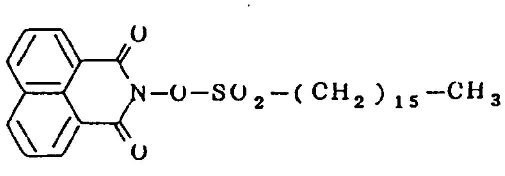

(XXVI-12)

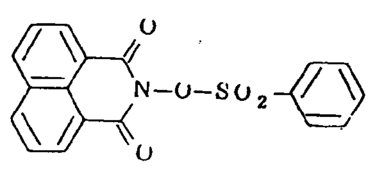

The amount of these compounds capable of generating acids to be added to the composition typically ranges from 0.001 to 40% by weight, preferably 0.1 to 20% by weight on the basis of the total weight of the solid

contents of the composition.

Alkali-soluble Polymers

The positive working light-sensitive composition of the present invention may comprise simply a combination of the components (a) and (b), but it may further comprise an alkali-soluble polymer.

The alkali-soluble polymers used in the composition are polymers carrying acidic hydrogen atom having a pKa value of not more than 11 such as phenolic hydroxyl group, carboxyl group, sulfonate residue, imido group, sulfonamido group, N-sulfonylamido group, N-sulfonylurethane group and/or active methylene group. Preferred alkali-soluble polymers are novolak type phenol resins such as phenol-formaldehyde resin, o-cresol-formaldehyde resin, m-cresol-formaldehyde resin, p-cresol-formaldehyde resin, xylenol-formaldehyde resin and co-condensates thereof. It is also possible to simultaneously use the aforesaid phenol resin and a condensate of phenol or cresol substituted with an alkyl group having 3 to 8 carbon atoms with formaldehyde such as t-butylphenol/formaldehyde resin as disclosed in J.P. KOKAI No. Sho 50-125806. Examples of other polymers usable in the invention are polymers comprising phenolic hydroxyl group-containing monomer such as N-(4-hydroxyphenyl) methacrylamide as a copolymerization component; homo- or copolymers of monomer(s) such as p-hydroxystyrene, o-hydroxystyrene, m-isopropenylphenol and/or p-isopropenylphenol and partially etherified or esterified products thereof.

Further, polymers comprising a carboxyl group-containing monomer such as acrylic acid and methacrylic acid as a copolymerization component; carboxyl group-containing polyvinyl acetal resins as disclosed in J.P. KOKAI No. Sho 61-267042; and carboxyl group-containing polyurethane resins as disclosed in J.P. KOKAI No. Sho 63-124047 can suitably be used.

Polymers comprising repeating units derived from monomers such as N-(4-sulfamoylphenyl) methacrylamide, N-phehnylsulfonyl methacrylamide and/or maleimide as copolymerization components; and active methylene group-containing polymers as disclosed in J.P. KOKAI No. Sho 63-127237 are also used in the composition of the invention.

These alkali-soluble polymers may be used alone or in combination. The amount of these alkali-soluble polymers to be incorporated into the light-sensitive composition preferably ranges from 10 to 90% by weight, more preferably 30 to 80% by weight on the basis of the total weight of the solid contents of the composition.

Other Preferred Components

The positive working light-sensitive composition of the present invention may optionally comprise other additives such as dyes, pigments, plasticizers and compounds for enhancing the acid-generating efficiency of the foregoing compounds (so-called sensitizers).

Such sensitizers for the acid generator represented by formulas (XXIII) and (XXIV) are, for instance, compounds disclosed in U.S. Patent Nos. 4,250,053 and 4,442,197. Specific examples thereof are anthracene, phenanthrene, perylene, pyrene, chrysene, 1,2-benzanthracene, coronene, 1,6-diphenyl-1,3,5-hexatriene, 1,1,4,4-tetraphenyl-1,3-butadiene, 2,3,4,5-tetraphenyl furan, 2,5-diphenylthiophene, thioxanthone, 2-chlorothioxanthone, phenothiazine, 1,3-diphenyl pyrazoline, 1,3-diphenyl isobenzofuran, xanthone, benzophenone, 4-hydroxybezophenone, anthrone, ninhydrin, 9-fluorenone, 2,4,7-trinitrofluorenone, indanone, phenanthraquinone, tetralone, 7-methoxy-4-methylcoumalin, 3-keto-bis(7-diethylaminocoumalin), Michler's ketone and ethyl Michler's ketone.

The molar ratio of these sensitizers to the compound capable of generating an acid by irradiation of actinic rays or radiant rays ranges from 0.01/1 to 20/1 and preferably 0.1/1 to 5/1.

In addition, days may be used as a coloring agent and preferred dyes include, for instance, oil-soluble dyes and basic dyes. Specific examples thereof are Oil Yellow #101, Oil Yellow #130, Oil Pink #312, Oil Green BG, Oil Blue BOS, Oil Blue #603, Oil Black BY, Oil Black BS, Oil Green BG, Oil Blue BOS, Oil Blue #603, Oil Black BY, Oil Black BS, Oil Black T-505 (these dyes being available from ORIENT CHEMICAL INDUSTRIES, LTD.), Crystal Violet (CI 42555), Methyl Violet (CI 42535), Rhodamine B (CI 45170 B), Malachite Green (CI 42000) and Methylene Blue (CI 52015).

The light-sensitive composition of the present invention may further comprise cyclic acid anhydrides and other fillers for further enhancing the sensitivity thereof. Examples of cyclic acid anhydrides are, as disclosed in U.S. Patent No. 4,115,128, phthalic anhydride, tetrahydrophthalic anhydride, hexahydrophthalic anhydride, 3.6-endoxy- $\Delta^4$-tetrahydrophthalic anhydride, tetrachlorophthalic anhydride, maleic anhydride, chloremaleic anhydride, $\alpha$-phenylmaleic anhydride, succinic anhydride and pyromellitic anhydride. The sensitivity can be increased as high as about 3 times at maximum by incorporating these cyclic acid anhydride into the composition in an amount of 1 to 15% by weight based on the total weight of the composition.

Solvent

The positive working light-sensitive composition of the present invention is dissolved in a solvent capable of dissolving the components of the composition and then applied onto the surface of a substrate if it is used as a material for PS plates. In addition if it is used as a resist for processing semiconductors or the like, it is dissolved in a solvent and the solution is used as such. Examples of such solvents herein used are ethylene dichloride, cyclohexanone, methyl ethyl ketone, methanol, ethanol, propanol, ethylene glycol monomethyl ether, 1-methoxy-2-propanol, ethylene glycol monoethyl ether, 2-methoxyethyl acetate, 1-methoxy-2-propyl acetate, dimethoxyethane, methyl lactate, ethyl lactate, N,N-dimethylacetamide, N,N-dimethylformamide, tetramethyl urea, N-methylpyrrolidone, dimethylsulfoxide, sulforane, $\gamma$-butyrolactone, toluene and ethyl acetate and these solvents can be used alone or in combination.

The concentration of the foregoing components (the total solid contents inclusive of additives) ranges from 2 to 50% by weight. When the solution is applied onto a substrate, the amount thereof coated varies depending on the applications and, for instance, as a rule it preferably ranges from 0.5 to 3.0 g/$m^2$ based on the solid contents for PS plates. As the amount thereof coated decreases, the light-sensitivity correspondingly increases, but, on the contrary, physical properties of the resultant film are impaired.

Preparation of PS plates or the Like

When a PS plate is prepared from the positive working light-sensitive composition of this invention, a substrate is in general used and examples thereof include paper, paper laminated with a plastic film such as polyethylene, polypropylene or polystyrene film; a metal plate such as an aluminum (inclusive of aluminum alloys), zinc or copper plate; a plastic film such as a cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film; and paper or a plastic film listed above which is laminated with a metal foil or on which a layer of the foregoing metal is deposited. Particularly preferred is an aluminum plate because of its high dimensional stability and low cost. Further, it is also preferred to use a composite sheet comprising a polyethylene terephthalate film on which an aluminum sheet is bonded as disclosed in J.P. KOKOKU No. Sho 48-18327. The surface of the aluminum plate is preferably grained by, for instance, mechanical methods such as wire brush graining, brush graining which comprises graining with a nylon brush with pouring a slurry of abrasive particles, ball graining, graining through liquid honing and buff graining; chemical graining methods such as those in which HF,$AlC\ell_3$ or $HC\ell$ is used as an etchant; electrolytic graining in which nitric acid or hydrochloric acid is used as an electrolyte; or combined graining comprising combinations thereof, then optionally etched with an acid or alkali and anodized in an electrolyte such as sulfuric acid, phosphoric acid, oxalic acid, boric acid, chromic acid, sulfamic acid or a mixture thereof using a DC or AC current to form a strong passivation film on the surface of the aluminum plate. Such a passivation film per se makes the aluminum plate surface hydrophilic, but it is particularly preferred that the aluminum plate is optionally hydrophilized by subjecting it to a silicate (sodium silicate, potassium silicate) treatment as disclosed in U.S. Patent Nos. 2,714,066 and 3,181,461; a potassium fluorozirconate treatment as disclosed in U.S. Patent No. 2,946,638; a phosphomolybdate treatment as disclosed in U.S. Patent No. 3,201,247; and alkyl titanate treatment as disclosed in U.K. Patent No. 1, 108,559; a polyacrylic acid treatment as disclosed in German Patent No. 1,091,433; a polyvinyl phosphonic acid treatment as disclosed in German Patent No. 1,134,093 and U.K. Patent No. 1,230,447; a phosphonic acid treatment as disclosed in J.P. KOKOKU No. Sho 44-6409; a phytic acid treatment as disclosed in U.S. Patent No. 3,307,951; a combined treatment with a hydrophilic organic polymeric compound and a bivalent metal as disclosed in J.P. KOKAI Nos. Sho 58-16893 and Sho 58-18291; a treatment by means of an underlying coating of an water-soluble polymer having sulfonate groups as disclosed in J.P. KOKAI No. Sho 59-101651. Examples of other hydrophilization treatments are silicate electrodeposition treatments as disclosed in U.S. Patent No. 3,658,662.

It is also preferred to use an aluminum plate which is subjected to a sealing treatment after graining and anodization treatments. Such a sealing treatment can be performed by immersing the aluminum plate in hot water or a hot aqueous solution containing an inorganic or organic salt or by means of a steam bath.

Actinic Rays or Radiant Rays

Light sources for actinic rays or radiant rays used in the present invention are, for instance, a mercury lamp, a metal halide lamp, a xenon lamp, a chemical lamp and a carbon arc lamp for actinic rays and electron rays, X-rays, ion beam and far ultraviolet rays for radiant rays. Preferred examples of light sources are g-rays, i-rays and Deep-UV rays for photoresists. In addition, a scanning exposure technique with a high energy density beam

such as laser beam or electron rays can be employed in the invention. Examples of such laser beam sources are a He · Ne laser, an Ar laser, a Kr ion laser, a He · Cd laser and KrF excimer laser.

Developer

Examples of developers for the positive working light-sensitive composition of the present invention preferably include an aqueous solution of an inorganic alkali agent such as sodium silicate, potassium silicate, sodium hydroxide, potassium hydroxide, lithium hydroxide, tertiary sodium phosphate, secondary sodium phosphate, tertiary ammonium phosphate, secondary ammonium phosphate, sodium metasilicate, sodium bicarbonate or ammonia or an organic alkali agent such as tetraalkyl ammonium hydroxide. These alkaline agents may be used alone or in combination. The concentration thereof ranges from 0.1 to 10% by weight and preferably 0.5 to 5% by weight.

These aqueous alkali solutions may optionally comprise a surfactant or an organic solvent such as an alcohol.

The present invention will hereunder be explained in more detail with reference to the following non-limitative working Examples and the effects practically achieved by the present invention will also be discussed in detail.

Examples 1 to 4

A 2S aluminum plate having a thickness of 0.24 mm was immersed in 10% aqueous solution of tertiary sodium phosphate maintained at 80 ° C for 3 minutes to degrease the same, grained with a nylon brush, etched with sodium aluminate solution for about 10 minutes and then desmutted with 3% aqueous solution of sodium hydrogen sulfate. The aluminum plate was then anodized at a current density of $2A/dm^2$ for 2 minutes in 20% sulfuric acid solution to thus obtain an aluminum substrate.

Four kinds of solutions, (A)-1 to (A)-4, of light-sensitive composition (hereunder referred to as "light-sensitive solutions") were prepared by changing the kinds of organopolysiloxane compounds used in the light-sensitive solution (A) having the following composition. Each of these light-sensitive solutions was applied onto the aluminum plate which had been anodized and dried at 100° C for 2 minutes to obtain the corresponding PS plates (A)-1 to (A)-4. The coated amount of the light-sensitive solution was 1.5 $g/m^2$ (weighed after drying) in all the PS plates.

The organopolysiloxane compounds used in the light-sensitive solutions (A)-1 to (A)-4 are listed in Table I given below.

Light-sensitive Solution (A)

| Component | Amount (g) |
|---|---|
| Cresol/formaldehyde novolak resin | 1.0 |
| Organopolysiloxane compound of the invention | 0.40 |
| $PF_6$ Salt of diphenyliodonium | 0.05 |
| Anthracene | 0.03 |
| Oil Blue #603 (available from ORIENT CHEMICAL INDUSTRIES, LTD.) | 0.01 |
| Methyl ethyl ketone | 5 |
| Methyl cellosolve | 15 |

A gray scale having a density difference of 0.15 was brought in close contact with the light-sensitive layer

of each PS plate (A)-1 to (A)-4 and the layer was exposed to light from a 2 KW high pressure mercury lamp at a distance of 50 nm for 2 minutes. The exposed PS plates (A)-1 to (A)-4 were immersed in and developed with DP-4 (trade name; available from Fuji Photo Film Co., Ltd.) diluted 8 times with water for 60 seconds at 25 ° C to thus obtain positive images dyed clear blue.

Table I

| Ex. No. | PS plate | Organopolysiloxane of the invention used |
|---|---|---|
| 1 | (A)-1 | Exemplified Compound (1) |
| 2 | (A)-2 | Exemplified Compound (2) |
| 3 | (A)-3 | Exemplified Compound (6) |
| 4 | (A)-4 | Exemplified Compound (18) |

Example 5

The following light-sensitive solution (B) was applied onto a silicon wafer with a spinner and dried on a hot plate maintained at 90 ° C for 2 minutes. The thickness of the layer was 1.0 µm.

Light-sensitive Solution (B)

| Component | Amount (g) |
|---|---|
| Cresol/formaldehyde novolak resin (m/p = 60/40) | 1.0 |
| Organopolysiloxane compound (Exemplified Compound (1)) | 0.40 |
| $PF_6$ Salt of diphenyliodonium | 0.05 |
| Perylene | 0.003 |
| Ethyl cellosolve acetate | 7.5 |

The resultant light-sensitive layer was exposed to light with a scale down projection aligner (stepper) using monochromatic light of 436 nm and developed with 2.4% aqueous solution of tetramethylammonium hydroxide for 60 seconds to form a resist pattern. As a result, a good pattern having a line & space of 0.8µm were obtained.

Example 6

A commercially available novolak type resist HPR-204 (available from Fuji Hunt Chemical Co., Ltd.) was applied onto a silicon wafer with a spinner and dried at 220 ° C for one hour to obtain an underlying coating. The thickness thereof was 2.0 µm.

The following light-sensitive solution (C) was applied onto the underlying layer with a spinner and dried on a hot plate maintained at 90 ° C for 2 minutes to form a coated film having a thickness of 0.5 µm.

Light-sensitive Solution (C)

| Component | Amount (g) |
|---|---|
| Poly-p-hydroxystyrene | 0.80 |
| Organopolysiloxane compound (Exemplified Compound (6)) | 0.70 |
| $SbF_6$ Salt of diphenyliodonium | 0.07 |
| Ethyl cellosolve acetate | 7.5 |

Then, the resultant layer was irradiated with ultraviolet rays of 254 nm through a glass mask in a close contact manner, thereafter developed in the same manner as in Example 5. As a result, a pattern having a line & space of 0.7 in μm could be resolved. The lower resist was then etched by oxygen plasma etching using oxygen gas plasma ($2.0 \times 10^{-2}$ Torr, RF 0.06 W/cm$^2$) and correspondingly the portions of the lower resist which had not been covered with the resist pattern was completely disappeared. In other words, it was confirmed that this resist could be used as an upper resist in the double layer resist method.

Examples 7 and 8

Two light-sensitive solutions (D)-1 and (D)-2 were prepared by changing the kinds of the organopolysiloxane compounds of the present invention used in the following light-sensitive solution (D) and applied onto the surface of the aluminum plate prepared in Examples 1 to 4. The plates were dried at 100° C for 2 minutes to thus obtain the corresponding PS plates (D)-1 and (D)-2. The amount of the solution coated was 1.5 g/m$^2$ (weighed after drying) for all the PS plates. The organopolysiloxane compounds of the present invention used in light-sensitive solutions (D)-1 and (D)-2 are listed in Table II given below.

Light-sensitive Solution (D)

| Component | Amount (g) |
|---|---|
| Organopolysiloxane compound as the component (b) | 1.0 |
| $PF_6$ Salt of triphenylsulfonium | 0.20 |
| Anthracene | 0.09 |
| Oil Blue #603 (available from ORIENT CHEMICAL INDUSTRIES CO., LTD.) | 0.01 |
| Methyl ethyl ketone | 5 |
| Methyl cellosolve | 15 |

A gray scale having a density difference of 0.15 was brought into close contact with the light-sensitive layer of each PS plate (D)-1 or (D)-2 thus obtained and exposed to light and developed in the same manner as in Examples 1 to 4 to thus obtain a positive pattern colored clear blue.

Table II

| Ex. No. | PS plate | Organopolysiloxane of the invention used |
|---|---|---|
| 7 | (D)-1 | Exemplified Compound (1) |
| 8 | (D)-2 | Exemplified Compound (6) |

## Claims

1. A positive working light-sensitive composition comprising (a) a compound capable of generating an acid through irradiation with actinic rays or radiant rays and (b) an organic polysiloxane compound having linear one-dimensional, branched or ladder type two-dimensional and/or three-dimensional network structures, wherein the compound capable of generating an acid through irradiation with actinic rays or radiant rays is selected from the group consisting of:

(1) oxadiazole derivatives and s-triazine derivatives represented by the following general formulas (XXI) and (XXII) respectively which are substituted with a trihalomethyl group:

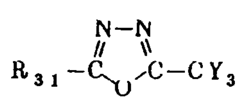

(XXI)

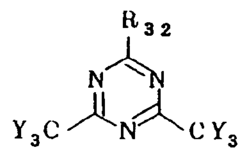

(XXII)

wherein Y represents a halogen atom, provided that three Y's may be the same or different; $R_{31}$ represents a substituted or unsubstituted aryl or alkenyl group; and $R_{32}$ represents $R_{31}$, $-CY_3$ or a substituted or unsubstituted alkyl group;

(2) iodonium and sulfonium salts represented by the following general formulas (XXIII) and (XXIV) respectively:

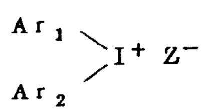

(XXIII)

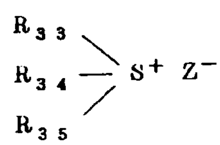

(XXIV)

wherein $Ar_1$ and $Ar_2$ may be the same or different and each represents an aromatic group which may be substituted with alkyl, haloalkyl, cycloalkyl, aryl, alkoxy, nitro, carbonyl, alkoxycarbonyl, hydroxyl and/or mercapto groups and/or halogen atoms; $R_{33}$, $R_{34}$ and $R_{35}$ may be the same or different and each represents an alkyl group having 1 to 8 carbon atoms which may be substituted with alkoxy groups having 1 to 8 carbon atoms, carbonyl group and/or alkoxycarbonyl groups or an aryl group having 6 to 14 carbon atoms which may be substituted with alkoxy groups having 1 to 8 carbon atoms, alkyl groups having 1 to 8 carbon atoms, nitro group, carbonyl group, hydroxyl group and/or halogen atoms; and $Z^-$ represents $BF_4^-$, $PF_6^-$, $AsF_6^-$, $SbF_6^-$, $C\ell O_4^-$ or $CF_3SO_3^-$, provided that two of $R_{33}$, $R_{34}$ and $R_{35}$, and $Ar_1$ and $Ar_2$ may be bonded through a single bond or a substituent;

(3) disulfone derivatives and imidosulfonate derivatives represented by the following general formulas (XXV) and (XXVI) respectively:

$$Ar_3 - SO_2 - SO_2 - Ar_4 \qquad (XXV)$$

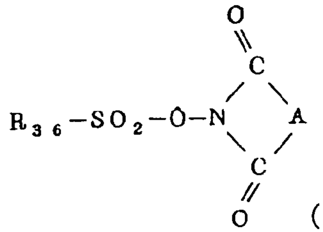

(XXVI)

wherein $Ar_3$ and $Ar_4$ may be the same or different and each represents a substituted or unsubstituted aryl group; $R_{36}$ represents a substituted or unsubstituted alkyl or aryl group and A represents a substituted or unsubstituted alkylene, alkenylene or arylene group; and
wherein the organopolysiloxane compound (b) is selected from those obtained by hydrolyzing or alkoxylating a compound represented by the following general formula (I), (II), (III), (IV) or (V) or a combination thereof and then condensing the resultant product:

$$R_1 - Si - (X)_3$$

(I) (II)

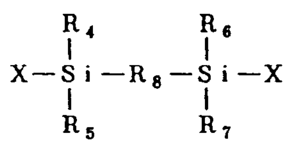

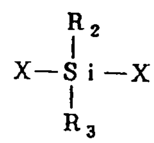

(III) (IV)

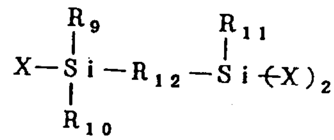

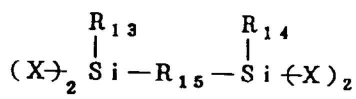

(V)

wherein $R_1$ to $R_7$, $R_9$ to $R_{11}$, $R_{13}$ and $R_{14}$ may be the same or different and each represents a hydrogen atom or an alkyl, substituted alkyl, substituted aryl, alkenyl, substituted alkenyl, silyl, substituted silyl, siloxy or substituted siloxy group; $R_8$, $R_{12}$ and $R_{15}$ may be the same or different and each represents a single bond or a bivalent alkylene, substituted alkylene, arylene or substituted arylene group; and X represents a hydrolyzable group.

2. The positive working light-sensitive composition of claim 1 wherein $R_1$ to $R_7$, $R_9$ to $R_{11}$, $R_{13}$ and $R_{14}$ each represents a hydrogen atom; an alkyl group having 1 to 10 carbon atoms which may be substituted with halogen atoms, alkoxy groups having 1 to 6 carbon atoms, aryl groups and/or aryloxy groups; a monocyclic or bicyclic aryl group which may be substituted with alkyl groups having 1 to 6 carbon atoms, alkoxy groups having 1 to 6 carbon atoms, halogen atoms, nitro group, phenyl group, carboxyl group, hydroxyl group, amido group, imido group and/or cyano group; a vinyl group which may be substituted with an aryl group; a silyl group which may be substituted with alkyl groups and/or aryl groups; or a substituted or unsubstituted siloxy group; $R_8$, $R_{12}$ and $R_{15}$ each represents a single bond, a linear, branched or cyclic alkylene group having 1 to 10 carbon atoms which may be substituted with halogen atoms, alkoxy groups having 1 to 6 carbon atoms and/or aryloxy groups having 6 to 10 carbon atoms; or a monocyclic or bicyclic arylene group which may be substituted with alkyl groups having 1 to 6 carbon atoms, alkoxy groups having 1 to 6 carbon atoms and/or halogen atoms; and X represents a halogen atom, an alkoxy group having 1 to 10 carbon atoms, an aryloxy group having 6 to 10 carbon atoms, an acyloxy group having 1 to 10 carbon atoms, an oxime group having 1 to 6 carbon atoms or an amido, ureido or amino group.

3. The positive working light-sensitive composition of claim 1 wherein the organopolysiloxane compound (b) is selected from the group consisting of those having a structure composed of one or more repeating units represented by the following general formulas (VI) to (XX):

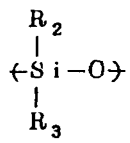

(VI)

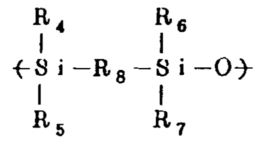

(VII)

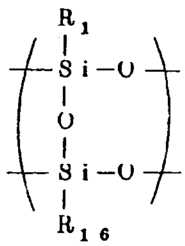

(VIII)

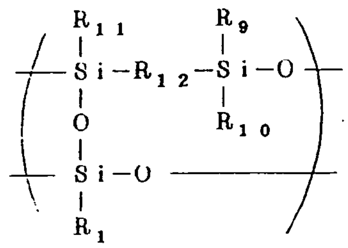

(IX)

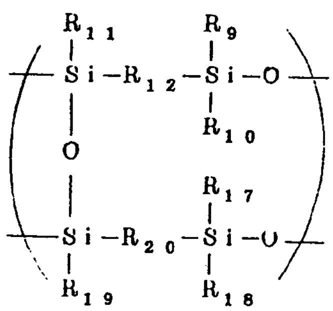

(X)

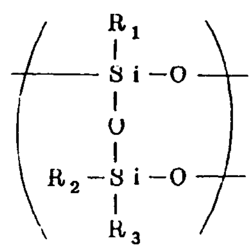

(XI)

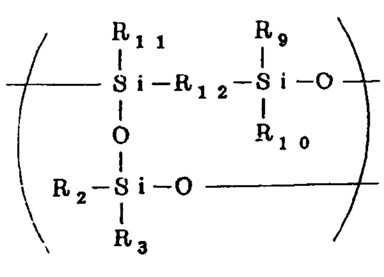

(XII)

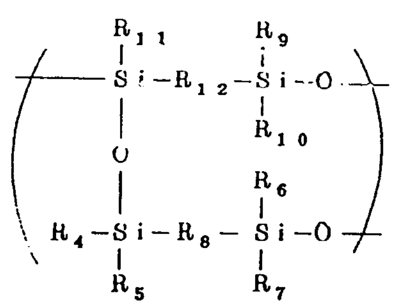

(XIII)

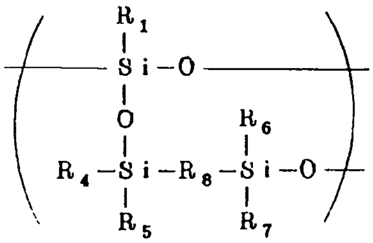

(XIV)

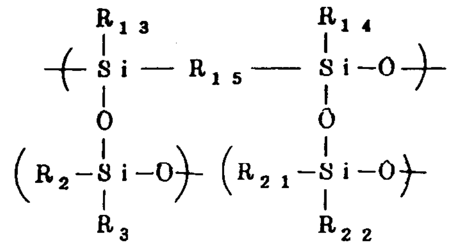

(XV)

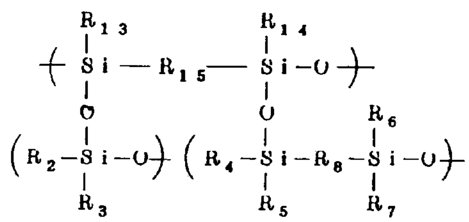

(XVI)

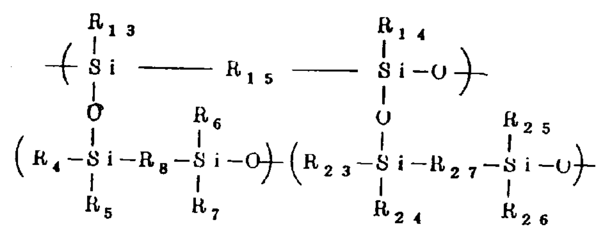

(XVII)

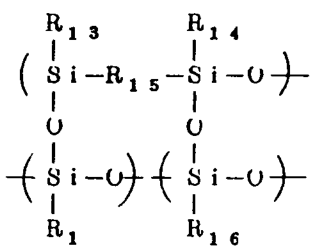

(XVIII)

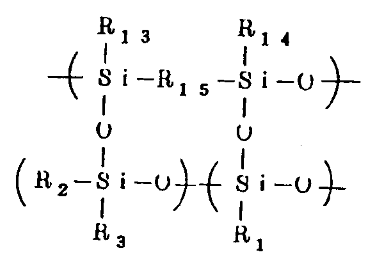

(XIX)

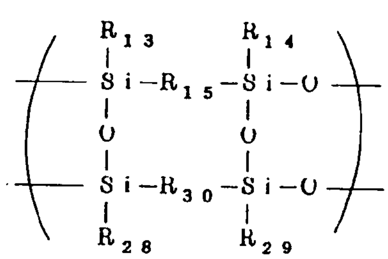

(XX)

wherein $R_{16}$ to $R_{19}$, $R_{21}$ to $R_{26}$, $R_{28}$ and $R_{29}$ may be the same or different and each has the same meanings as defined above in connection with $R_1$ to $R_7$, $R_9$ to $R_{11}$, $R_{13}$ and $R_{14}$; and $R_{20}$, $R_{27}$ and $R_{30}$ may be the same or different and each has the same meanings as defined above in connection with $R_8$, $R_{12}$ and $R_{15}$.

4. The positive working light-sensitive composition of any one of claims 1 to 3 wherein the weight-average molecular weight of the organopolysiloxane compound is not less than 500.

5. The positive working light-sensitive composition of claim 4 wherein the weight-average molecular weight of the organopolysiloxane compound ranges from 1,000 to 500,000.

6. The positive working light-sensitive composition of any one of claims 1 to 5 wherein the amount of the compound capable of generating an acid ranges from 0.001 to 40% by weight on the basis of the total weight of the solid contents of the composition.

7. The positive working light-sensitive composition of claim 6 wherein the amount of the compound capable of generating an acid ranges from 0.1 to 20% by weight on the basis of the total weight of the solid contents of the composition.

8. The positive working light-sensitive composition of any one of claims 1 to 7 wherein it further comprises an alkali-soluble polymer.

9. The positive working light-sensitive composition of claim 8 wherein the alkali-soluble polymer is selected from the group consisting of those carrying active hydrogen atoms having a pKa value of not more than 11.

10. The positive working light-sensitive composition of claim 9 wherein the alkali-soluble polymer is selected from the group consisting of those carrying phenolic hydroxide, carboxyl, imido, sulfonamido, N-sulfonylamido, N-sulfonylurethane and/or active methylene groups.

11. The positive working light-sensitive composition of claim 8 wherein the alkali-soluble polymer is an alkali-soluble novolak type phenol resin.

12. The positive working light-sensitive composition of any one of claims 8 to 11 wherein the amount of the alkali-soluble polymer ranges from 10 to 90% by weight based on the total weight of the solid contents of the light-sensitive composition.

13. The positive working light-sensitive composition of claim 12 wherein the amount of the alkali-soluble polymer ranges from 30 to 80% by weight based on the total weight of the solid contents of the light-sensitive composition.

14. The positive working light-sensitive composition of any one of claims 1 to 13 wherein it comprises dyes, pigments, plasticizers and/or compounds capable of enhancing the acid generating efficiency of the compound capable of generating an acid.

15. The positive working light-sensitive composition of claim 14 wherein the acid generating efficiency enhancing compound is selected from anthracene, phenanthrene, perylene, pyrene, chrycene, 1,2-benzanthracene, coronene, 1,6-diphenyl-1,3,5-hexatriene, 1,1,4,4,-tetraphenyl-1,3-butadiene, 2,3,4,5-tetraphenyl furan, 2,5-diphenylthiophene, thioxanthone, 2-chlorothioxanthone, phenothiazine, 1,3-diphenyl pyrazoline, 1,3-diphenyl isobenzofuran, xanthone, benzophenone, 4-hydroxybenzophenone, anthrone, ninhydrin, 9-fluorenone, 2,4,7-trinitrofluorenone, indanone, phenanthraquinone, tetralone, 7-methoxy-4-methylcoumalin, 3-keto-bis(7-diethylaminocoumalin), Michler's ketone and ethyl Michler's ketone.

16. The positive working light-sensitive composition of claim 14 or 15 wherein the molar ratio of the acid generating efficiency enhancing compound to the compound capable of generating an acid ranges from 0.01/1 to 20/1.

17. The positive working light-sensitive composition of any one of claims 1 to 16 wherein it comprises a cyclic anhydride and/or a filler.

18. The positive working light-sensitive composition of claim 17 wherein the amount of the cyclic anhydride ranges from 1 to 15% by weight on the basis of the total weight of the composition.

**Patentansprüche**

1. Positiv arbeitende lichtempfindliche Zusammensetzung, umfassend (a) eine Verbindung, die durch Bestrahlung mit aktinischen Strahlen oder Lichtstrahlen eine Säure bilden kann, und (b) eine organische Polysiloxan-Verbindung mit linearen, eindimensionalen, verzweigten oder Leiter-artigen zweidimensionalen und/oder dreidimensionalen Netzwerk-Strukturen, wobei die Verbindung, die durch Bestrahlung mit aktinischen Strahlen oder Lichtstahlen (Radiostrahlen) eine Säure bilden kann, ausgewählt wird aus der Gruppe, die besteht aus:

1) Oxadiazolderivaten und s-Triazinderivaten, jeweils dargestellt durch die folgenden allgemeinen Formeln (XXI) und (XXII), die substituiert sind durch eine Trihalogenmethylgruppe:

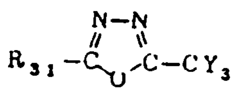

(XXI)

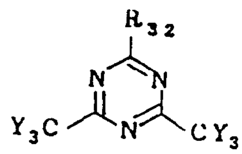

(XXII)

worin bedeuten:

Y ein Halogenatom, mit der Maßgabe, daß die drei Y-Reste gleich oder verschieden sein können;

$R_{31}$ eine substituierte oder unsubstituierte Aryl- oder Alkenylgruppe; und

$R_{32}$ den Rest $R_{31}$, $-CY_3$ oder eine substituierte oder unsubstituierte Alkylgruppe;

2) Jodonium- und Sulfoniumsalze, jeweils dargestellt durch die folgenden allgemeinen Formeln (XXIII) und (XXIV):

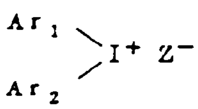

(XXIII)

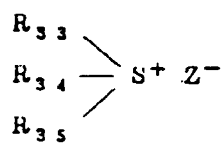

(XXIV)

worin bedeuten:

$Ar_1$ und $Ar_2$, die gleich oder verschieden sein können, jeweils eine aromatische Gruppe, die substituiert sein kann durch Alkyl-, Halogenalkyl-, Cycloalkyl-, Aryl-, Alkoxy-, Nitro-, Carbonyl-, Alkoxycarbonyl-, Hydroxyl- und/oder Mercaptogruppen und/oder Halogenatome;

$R_{33}$, $R_{34}$ und $R_{35}$, die gleich oder verschieden sein können, jeweils eine Alkylgruppe mit 1 bis 8 Kohlenstoffatomen, die substituiert sein kann durch Alkoxygruppen mit 1 bis 8 Kohlenstoffatomen, eine Carbonylgruppe und/oder Alkoxycarbonylgruppen oder eine Arylgruppe mit 6 bis 14 Kohlenstoffatomen, die substituiert sein kann durch Alkoxygruppen mit 1 bis 8 Kohlenstoffatomen, Alkylgruppen mit 1 bis 8 Kohlenstoffatomen, eine Nitrogruppe, eine Carbonylgruppe, eine Hydroxylgruppe und/oder Halogenatome; und

$Z^-$ $BF_4^-$, $PF_6^-$, $AsF_6^-$, $SbF_6^-$, $ClO_4^-$ oder $CF_3SO_3^-$, mit der Maßgabe, daß zwei der Reste $R_{33}$, $R_{34}$ und $R_{35}$ und $Ar_1$ und $Ar_2$ durch eine Einfachbindung oder einen Substituenten miteinander verbunden sein können;

3) Disulfonderivate und Imidosulfonatderivate, jeweils dargestellt durch die folgenden allgemeinen Formeln (XXV) und (XXVI):

$$Ar_3 - SO_2 - SO_2 - Ar_4 \qquad (XXV)$$

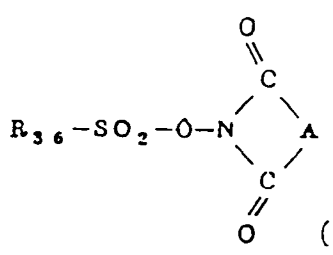

(XXVI)

worin bedeuten:

$Ar_3$ und $Ar_4$, die gleich oder verschieden sein können, jeweils eine substituierte oder unsubstituierte Arylgruppe;

$R_{36}$ eine substituierte oder unsubstituierte Alkyl- oder Arylgruppe und

A eine substituierte oder unsubstituierte Alkylen-, Alkenylen- oder Arylengruppe;

wobei die Organopolysiloxan-Verbindung (b) ausgewählt wird aus solchen, die erhalten wurden durch Hydrolysieren oder Alkoxylieren einer Verbindung, dargestellt durch die folgende allgemeine Formel (I), (II), (III), (IV) oder (V) oder einer Kombination davon und anschließendes Kondensieren des resultierenden Produkts:

$$R_1 - Si - (X)_3$$

(I)

(II)

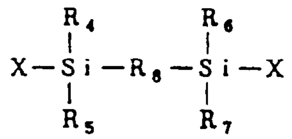

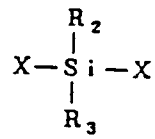

(III)

(IV)

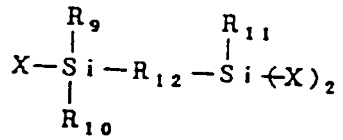

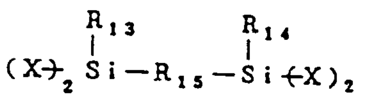

(V)

worin $R_1$ bis $R_7$, Rg bis $R_{11}$, $R_{13}$ und $R_{14}$ gleich oder verschieden sein können und jeweils stehen für ein Wasserstoffatom oder eine Alkyl-, substituierte Alkyl-, substituierte Aryl-, Alkenyl-, substituierte Alkenyl-, Silyl-, substituierte Silyl-, Siloxy- oder substituierte Siloxygruppe; $R_8$, $R_{12}$ und $R_{15}$ gleich oder verschieden sein können und jeweils stehen für eine Einfachbindung oder eine bivalente Alkylen-, substituierte Alkylen-, Arylen- oder substituierte Arylengruppe; und X steht für eine hydrolysierbare Gruppe.

2. Positiv arbeitende lichtempfindliche Zusammensetzuung nach Anspruch 1, worin $R_1$ bis $R_7$, $R_9$ bis $R_{11}$, $R_{13}$ und $R_{14}$ jeweils stehen für ein Wasserstoffatom; eine Alkylgruppe mit 1 bis 10 Kohlenstoffatomen, die substituiert sein kann durch Halogenatome, Alkoxygruppen mit 1 bis 6 Kohlenstoffatomen, Arylgruppen und/oder Aryloxygruppen; eine monocyclische oder bicyclische Arylgruppe, die substituiert sein kann durch Alkylgruppen mit 1 bis 6 Kohlenstoffatomen, Alkoxygruppen mit 1 bis 6 Kohlenstoffatomen, Halogenatome, eine Nitrogruppe, eine Phenylgruppe, eine Carboxylgruppe, eine Hydroxylgruppe, eine Amidogruppe, eine Imidogruppe und/oder eine Cyanogruppe; eine Vinylgruppe, die substituiert sein kann durch eine Arylgruppe; eine Silylgruppe, die substituiert sein kann durch Alkylgruppen und/oder Arylgruppen; oder eine substituierte oder unsubstituierte Siloxygruppe; $R_8$, $R_{12}$ und $R_{15}$ jeweils stehen für eine Einfachbindung, eine lineare, verzweigte oder cyclische Alkylengruppe mit 1 bis 10 Kohlenstoffatomen, die substituiert sein kann durch Halogenatome, Alkoxygruppen mit 1 bis 6 Kohlenstoffatomen und/oder Aryloxygruppen mit 6 bis 10 Kohlenstoffatomen; oder eine monocyclische oder bicyclische Arylengruppe, die substituiert sein kann durch Alkylgruppen mit 1 bis 6 Kohlenstoffatomen, Alkoxygruppen mit 1 bis 6 Kohlenstoffatomen und/oder Halogenatomen; und X steht für ein Halogenatom, eine Alkoxygruppe mit 1 bis 10 Kohlenstoffatomen, eine Aryloxygruppe mit 6 bis 10 Kohlenstoffatomen, eine Acyloxygruppe mit 1 bis 10 Kohlenstoffatomen, eine Oximgruppe mit 1 bis 6 Kohlenstoffatomen oder eine Amido-, Ureido- oder Aminogruppe.

3. Positiv arbeitende lichtempfindliche Zusammensetzung nach Anspruch 1, worin die Organopolysiloxan-Verbindung (b) ausgewählt wird aus der Gruppe, die besteht aus solchen, die eine Struktur haben, die aufgebaut ist aus einer oder mehr wiederkehrenden Einheiten, dargestellt durch die folgenden allgemeinen Formeln (VI) bis (XX):

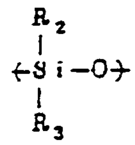

(VI)

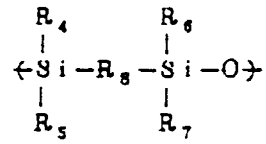

(VII)

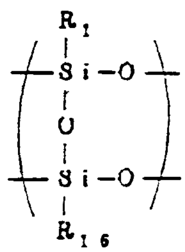

(VIII)

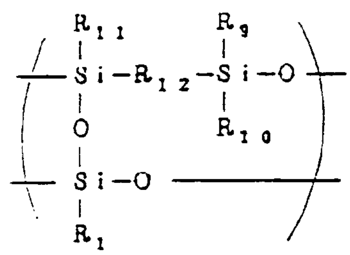

(IX)

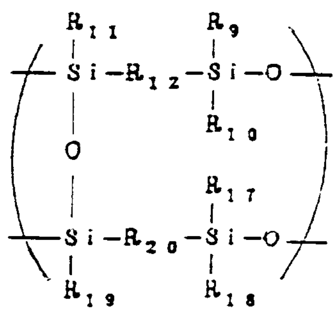

(X)

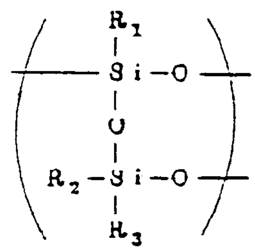

(XI)

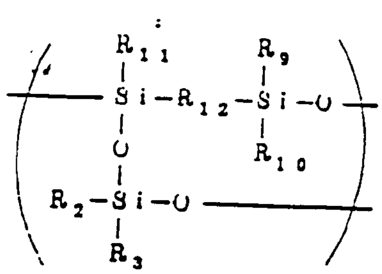

(XII)

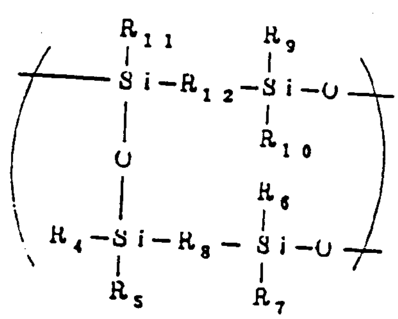

(XIII)

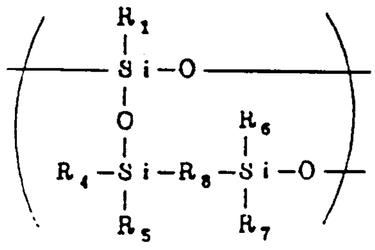

(XIV)

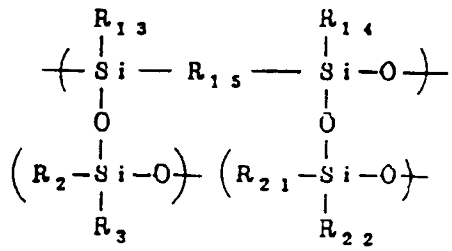

(XV)

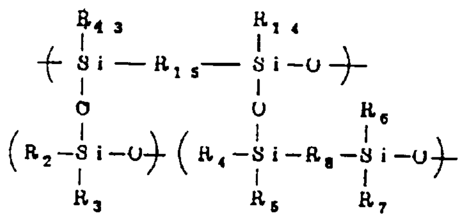

(XVI)

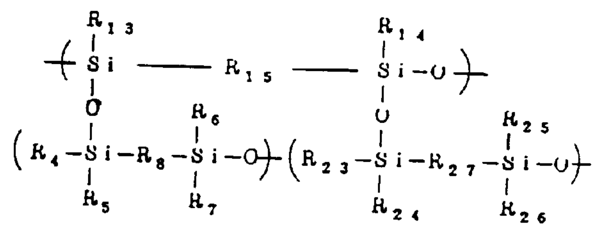

(XVII)

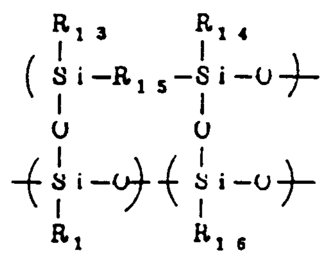

(XVIII)

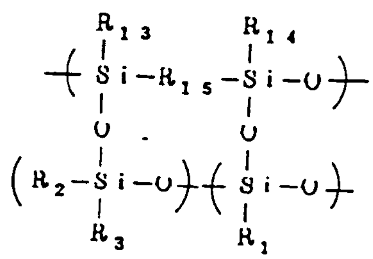

(XIX)

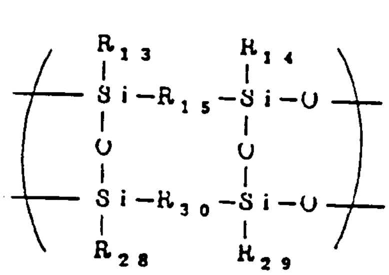

(XX)

worin $R_{16}$ bis $R_{19}$, $R_{21}$ bis $R_{26}$, $R_{28}$ und $R_{29}$ gleich oder verschieden sein können und jeweils die gleichen Bedeutungen haben, wie sie oben in Verbindung mit $R_1$ bis $R_7$, $R_9$ bis $R_{11}$, $R_{13}$ und $R_{14}$ angegeben worden sind; und $R_{20}$, $R_{27}$ und $R_{30}$ gleich oder verschieden sein können und jeweils die gleichen Bedeutungen haben, wie sie oben in Verbindung mit $R_8$, $R_{12}$ und $R_{15}$ angegeben worden sind.

4. Positiv arbeitende lichtempfindliche Zusammensetzung nach einem der Ansprüche 1 bis 3, worin das gewichtsdurchschnittliche Molekulargewicht der Organopolysiloxanverbindung nicht weniger als 500 beträgt.

5. Positiv arbeitende lichtempfindliche Zusammensetzung nach Anspruch 4, worin das gewichtsdurchschnittliche Molekulargewicht der Organopolysiloxan-Verbindung in dem Bereich von 1000 bis 500 000 liegt.

6. Positiv arbeitende lichtempfindliche Zusammensetzung nach einem der Ansprüche 1 bis 5, worin die Menge der Verbindung, die eine Säure bilden kann, in dem Bereich von 0,001 bis 40 Gew.-%, bezogen auf das Gesamtgewicht der Feststoffgehalte der Zusammensetzung, liegt.

7. Positiv arbeitende lichtempfindliche Zusammensetzung nach Anspruch 6, worin die Menge der Verbindung, die eine Säure bilden kann, in dem Bereich von 0,1 bis 20 Gew.-%, bezogen auf das Gesamtgewicht der Feststoffgehalte der Zusammensetzung, liegt.

8. Positiv arbeitende lichtempfindliche Zusammensetzung nach einem der Ansprüche 1 bis 7, die außerdem ein alkalilösliches Polymer enthält.

9. Positiv arbeitende lichtempfindliche Zusammensetzung nach Anspruch 8, worin das alkalilösliche Polymer ausgewählt wird aus der Gruppe, die besteht aus solchen, die aktive Wasserstoffatome tragen, mit einem pKa-Wert von nicht mehr als 11.

10. Positiv arbeitende lichtempfindliche Zusammensetzung nach Anspruch 9, worin das alkalilösliche Polymer ausgewählt wird aus der Gruppe, die besteht aus solchen, die phenolische Hydroxid-, Carboxyl-, Imido-, Sulfonamido-, N-Sulfonylamido-, N-Sulfonylurethan- und/oder aktive Methylengruppen tragen.

11. Positiv arbeitende lichtempfindliche Zusammensetzung nach Anspruch 8, worin das alkalilösliche Polymer ein alkalilösliches Phenolharz vom Novolak-Typ ist.

12. Positiv arbeitende lichtempfindliche Zusammensetzung nach einem der Ansprüche 8 bis 11, worin die Menge des alkalilöslichen Polymers in dem Bereich von 10 bis 90 Gew.-%, bezogen auf das Gesamtgewicht der Feststoffgehalte der lichtempfindliche Zusammensetzung, liegt.

13. Positiv arbeitende lichtempfindliche Zusammensetzung nach Anspruch 12, worin die Menge des alkalilöslichen Polymers in dem Bereich von 30 bis 80 Gew.-%, bezogen auf das Gesamtgewicht der Feststoffgehalte der lichtempfindliche Zusammensetzung, liegt.

14. Positiv arbeitende lichtempfindliche Zusammensetzung nach einem der Ansprüche 1 bis 13, die enthält Farbstoffe, Pigmente, Weichmacher und/oder Verbindungen, welche den Säurebildungs-Wirkungsgrad der Verbindung, die eine Säure bilden kann, verbessern können.

15. Positiv arbeitende lichtempfindliche Zusammensetzung nach Anspruch 14, worin die den Säurebildungs-Wirkungsgrad verbessernde Verbindung ausgewählt wird aus Anthracen, Phenanthren, Perylen, Pyren, Chrysen, 1,2-Benzanthracen, Coronen, 1,6-Diphenyl-1,3,5-hexatrien, 1,1,4,4-Tetraphenyl-1,3-butadien, 2,3,4,5-Tetraphenylfuran, 2,5-Diphenylthiophen, Thioxanthon, 2-Chlorothioxanthon, Phenothiazin, 1,3-Diphenyl-pyrazolin, 1,3-Diphenyl-isobenzofuran, Xanthon, Benzophenon, 4-Hydroxybenzophenon, Anthron, Ninhydrin, 9-Fluorenon, 2,4,7-Trinitrofluorenon, Indanon, Phenanthrachinon, Tetralon, 7-Methoxy-4-methylcoumalin, 3-Keto-bis(7-diethylaminocoumalin), Michler's Keton und Ethyl-Michler's Keton.

16. Positiv arbeitende lichtempfindliche Zusammensetzung nach Anspruch 14 oder 15, worin das Molverhältnis zwischen der den Säurebildungs-Wirkungsgrad verbessernden Verbindung und der Verbindung, die eine Säure bilden kann, in dem Bereich von 0,01/1 bis 20/1 liegt.

17. Positiv arbeitende lichtempfindliche Zusammensetzung nach einem der Ansprüche 1 bis 16, die ein cyclisches Anhydrid und/oder einen Füllstoff enthält.

18. Positiv arbeitende lichtempfindliche Zusammensetzung nach Anspruch 17, worin die Menge des cyclischen Anhydrids in dem Bereich von 1 bis 15 Gew.-%, bezogen auf das Gesamtgewicht der Zusammensetzung, liegt.

## Revendications

1. Composition photosensible positive comprenant un composé (a) capable de produire un acide lorsqu'il est irradié par des rayons actiniques ou des radiations rayonnantes et (b) un composé polysiloxane organique possédant des structures à réseau unidimensionnel linéaire, bidimensionnel ramifé ou à échelle et/ou tridimensionnel,
dans laquelle le composé capable de produire un acide lorsqu'il est irradié par des rayons actiniques ou des radiations rayonnantes est choisi dans le groupe constitué par :
(1) les dérivés oxadiazoles et les dérivés s-triazines représentés respectivement par les formules générales (XXI) et (XXII) suivantes, qui sont substitués par un groupe trihalogénométhyle :

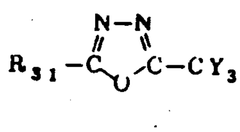

(XXI)

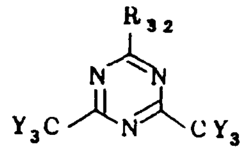

(XXII)

dans lesquelles Y représente un atome d'halogène, à condition que les trois Y puissent être identiques ou différents; $R_{31}$ représente un groupe aryle ou alcényle substitué ou non substitué; et $R_{32}$ représente $R_{31}$, $-CY_3$ ou un groupe alkyle substitué ou non substitué;
(2) les sels d'iodonium et de sulfonium représentés respectivement par les formules générales (XXIII) et (XXIV) suivantes :

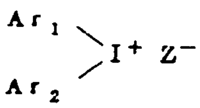

(XXIII)

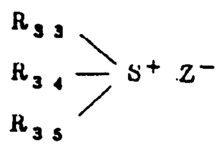

(XXIV)

dans lesquelles $Ar_1$ et $Ar_2$ peuvent être identiques ou différents et chacun représente un groupe aromatique qui peut être substitué par des groupes alkyle, halogénoalkyle, cycloalkyle, aryle, alcoxy, nitro, carbonyle, alcoxycarbonyle, hydroxyle et/ou mercapto et/ou par des atomes d'halogène; $R_{33}$, $R_{34}$ et $R_{35}$ peuvent être identiques ou différents et chacun représente un groupe alkyle comportant 1 à 8 atomes de carbone, qui peut être substitué par des groupes alcoxy comportant 1 à 8 atomes de carbone, un groupe carbonyle et/ou des groupes alcoxycarbonyle, ou un groupe aryle comportant 6 à 14 atomes de carbone, qui peut être substitué par des groupes alcoxy comportant 1 à 8 atomes de carbone, des groupes alkyle comportant 1 à 8 atomes de carbone, un groupe nitro, un groupe carbonyle, un groupe hydroxyle et/ou des atomes d'halogène; et $Z^-$ représente $BF_4^-$, $PF_6^-$, $AsF_6^-$, $SbF_6^-$, $ClO_4^-$ ou $CF_3SO_3^-$, à condition que deux des groupes $R_{33}$, $R_{34}$ et $R_{35}$, et $Ar_1$ et $Ar_2$, puissent être liés par une simple liaison ou un substituant;
(3) les dérivés disulfones et les dérivés imidosulfonates représentés respectivement par les formules générales (XXV) et (XXVI) suivantes :

$Ar_3 - SO_2 - SO_2 - Ar_4$ (XXV)

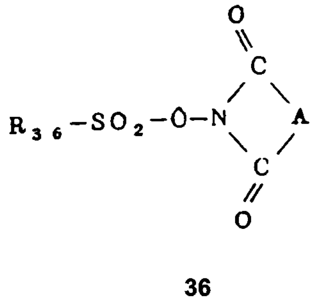

(XXVI)

dans lesquelles $Ar_3$ et $Ar_4$ peuvent être identiques ou différents et chacun représente un groupe aryle substitué ou non substitué; $R_{36}$ représente un groupe alkyle ou aryle substitué ou non substitué et A représente un groupe alkylène, alcénylène ou arylène substitué ou non substitué; et

dans laquelle le composé organopolysiloxane (b) est choisi parmi ceux obtenus par hydrolyse ou alcoxylation d'un composé représenté par la formule générale (I), (II), (III), (IV) ou (V) suivante, ou une combinaison de celles-ci, puis condensation du produit résultant :

$$R_1 - Si - (X)_3$$

(I)

(II)

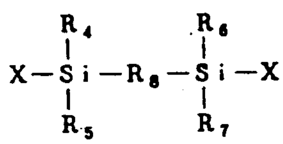

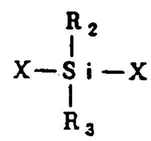

(III)

(IV)

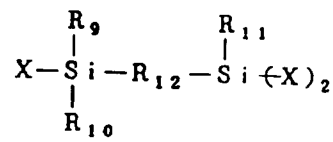

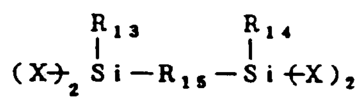

(V)

où $R_1$ à $R_7$, $R_9$ à $R_{11}$, $R_{13}$ et $R_{14}$ peuvent être identiques ou différents et chacun représente un atome d'hydrogène ou un groupe alkyle, alkyle substitué, aryle substitué, alcényle, alcényle substitué, silyle, silyle substitué, siloxy ou siloxy substitué; $R_8$, $R_{12}$ et $R_{15}$ peuvent être identiques ou différents et chacun représente une simple liaison ou un groupe alkylène divalent, alkylène substitué, arylène ou arylène substitué; et X représente un groupe hydrolysable.

2. Composition photosensible positive selon la revendication 1, dans laquelle $R_1$ à $R_7$, $R_9$ à $R_{11}$, $R_{13}$ et $R_{14}$ représentent chacun un atome d'hydrogène; un groupe alkyle comportant 1 à 10 atomes de carbone qui peut être substitué par des atomes d'halogène, des groupes alcoxy comportant 1 à 6 atomes de carbone, des groupes aryle et/ou des groupes aryloxy; un groupe aryle monocyclique ou bicyclique qui peut être substitué par des groupes alkyle comportant 1 à 6 atomes de carbone, des groupes alcoxy comportant 1 à 6 atomes de carbone, des atomes d'halogène, un groupe nitro, un groupe phényle, un groupe carboxyle un groupe hydroxyle, un groupe amido, un groupe imido et/ou un groupe cyano; un groupe vinyle qui peut être substitué par un groupe aryle; un groupe silyle qui peut être substitué par des groupes alkyle et/ou des groupes aryle; ou un groupe siloxy substitué ou non substitué; $R_8$, $R_{12}$ et $R_{15}$ représentent chacun une simple liaison, un groupe alkylène linéaire, ramifié ou cyclique comportant 1 à 10 atomes de carbone qui peut être substitué par des atomes d'halogène, des groupes alcoxy comportant 1 à 6 atomes de carbone et/ou des groupes aryloxy comportant 6 à 10 atomes de carbone; ou un groupe arylène monocyclique ou bicyclique qui peut être substitué par des groupes alkyle comportant 1 à 6 atomes de carbone, des groupes alcoxy comportant 1 à 6 atomes de carbone et/ou des atomes d'halogène; et X représente un atome d'halogène, un groupe alcoxy comportant 1 à 10 atomes de carbone, un groupe aryloxy comportant 6 à 10 atomes de carbone, un groupe acyloxy comportant 1 à 10 atomes de carbone, un groupe oxime comportant 1 à 6 atomes de carbone ou un groupe amido, uréido ou amino.

3. Composition photosensible positive selon la revendication 1, dans laquelle le composé organopolysiloxane (b) est choisi dans le groupe de ceux qui ont une structure composée d'un ou plusieurs motifs récurrents représentés par les formules générales (VI) à (XX) suivantes :

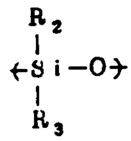

(VI)

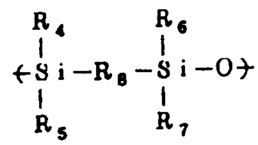

(VII)

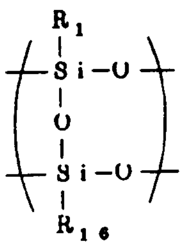

(VIII)

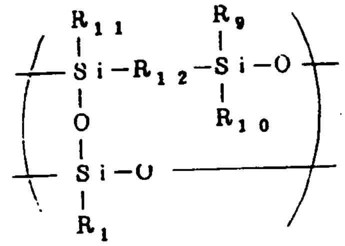

(IX)

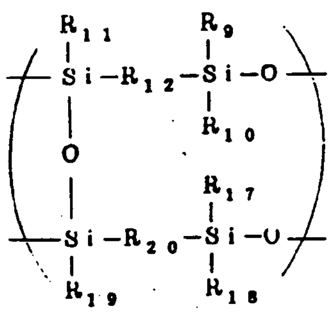

(X)

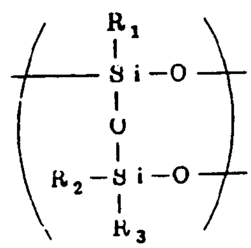

(XI)

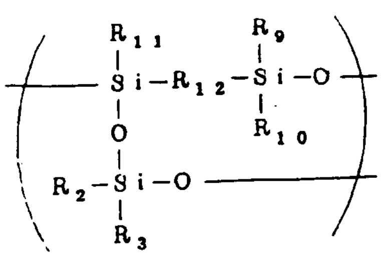

(XII)

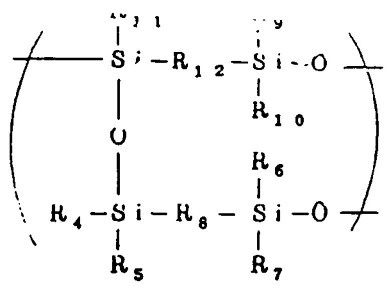

(XIII)

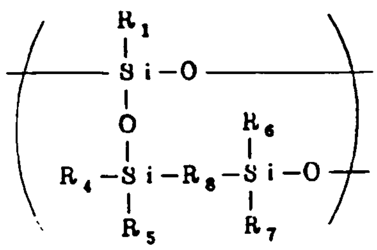

(XIV)

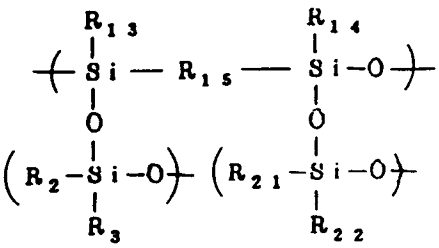

(XV)

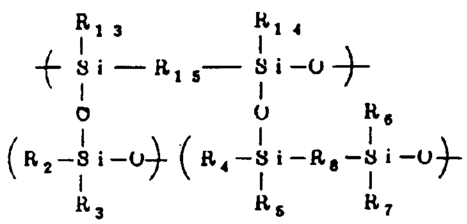

(XVI)

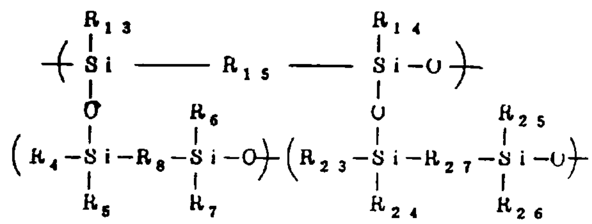

(XVII)

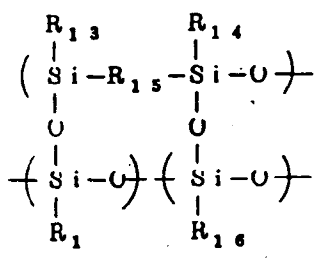

(XVIII)

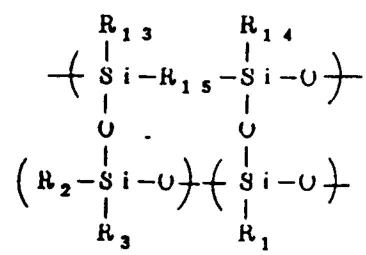

(XIX)

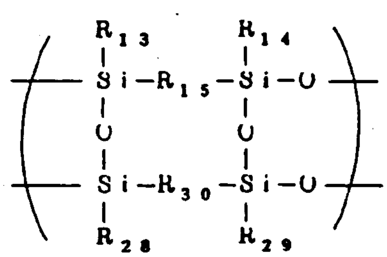

(XX)

dans lesquelles $R_{16}$ à $R_{19}$, $R_{21}$ à $R_{26}$, $R_{28}$ et $R_{29}$ peuvent être identiques ou différents et ont chacun les significations définies ci-dessus pour $R_1$ à $R_7$, $R_9$ à $R_{11}$, $R_{13}$ et $R_{14}$; et $R_{20}$, $R_{27}$ et $R_{30}$ peuvent être identiques ou différents et ont chacun les significations définies ci-dessus pour $R_8$, $R_{12}$ et $R_{15}$.

4. Composition photosensible positive selon l'une quelconque des revendications 1 à 3, dans laquelle la masse moléculaire moyenne en poids du composé organopolysiloxane n'est pas inférieure à 500.

5. Composition photosensible positive selon la revendication 4, dans laquelle la masse moléculaire moyenne en poids du composé organopolysiloxane est de 1 000 à 500 000.

6. Composition photosensible positive selon l'une quelconque des revendications 1 à 5, dans laquelle la quantité de composé capable de produire un acide s'échelonne de 0,001 à 40% en poids, par rapport au poids total de la teneur en solides de la composition.

7. Composition photosensible positive selon la revendication 6, dans laquelle la quantité de composé capable de produire un acide s'échelonne de 0,1 à 20% en poids, par rapport au poids total de la teneur en solides de la composition.

8. Composition photosensible positive selon l'une quelconque des revendications 1 à 7, comprenant en outre un polymère soluble dans les bases.

9. Composition photosensible positive selon la revendication 8, dans laquelle le polymère soluble dans les bases est choisi dans le groupe de ceux qui portent des atomes d'hydrogène actif et dont le pKa n'est pas supérieur à 11.

10. Composition photosensible positive selon la revendication 9, dans laquelle le polymère soluble dans les bases est choisi dans le groupe de ceux qui portent des groupes hydroxyde phénolique, carboxyle, imido, sulfonamido, N-sulfonylamido, N-sulfonyluréthane et/ou des groupes méthylène actifs.

11. Composition photosensible positive selon la revendication 8, dans laquelle le polymère soluble dans les bases est une résine phénolique de type novolaque soluble dans les bases.

12. Composition photosensible positive selon l'une quelconque des revendications 8 à 11, dans laquelle la quantité de polymère soluble dans les bases s'échelonne de 10 à 90% en poids, par rapport au poids total de la teneur en solides de la composition photosensible.

13. Composition photosensible positive selon la revendication 12, dans laquelle la quantité de polymère soluble dans les bases s'échelonne de 30 à 80% en poids, par rapport au poids total de la teneur en solides de la composition photosensible.

14. Composition photosensible positive selon l'une quelconque des revendications 5 à 13, qui comprend des colorants, des pigments, des plastifiants et/ou des composés capables d'améliorer le rendement de production d'acide du composé capable de produire un acide.

15. Composition photosensible positive selon la revendication 14, dans laquelle le composé améliorant le rendement de production d'acide est choisi parmi l'anthracène, le phénanthrène, le pérylène, le pyrène, le chrycène, le 1,2-benzanthracène, le coronène, le 1,6-diphényl-1,3,5-hexatriène, le 1,1,4,4-tétraphényl-1,3-butadiène, le 2,3,4,5-tétraphénylfuranne, le 2,5-diphénylthiophène, la thioxanthone, la 2-chlorothioxanthone, la phénothiazine, la 1,3-diphénylpyrazoline, le 1,3-diphénylisobenzofuranne, la xanthone, la benzophénone, la 4-hydroxybenzophénone, l'anthrone, la ninhydrine, la 9-fluorénone, la 2,4,7-trinitrofluorénone, l'indanone, la phénanthraquinone, la tétralone, la 7-méthoxy-4-méthylcoumaline, la 3-cétobis(7-diéthylaminocoumaline), la cétone de Michler et l'éthylcétone de Michler.

16. Composition photosensible positive selon la revendication 14 ou 15, dans laquelle le rapport molaire du composé améliorant le rendement de production d'acide au composé capable de produire un acide s'échelonne de 0,01/1 à 20/1.

17. Composition photosensible positive selon l'une quelconque des revendications 1 à 16, qui comprend un anhydride cyclique et/ou une charge.

18. Composition photosensible positive selon la revendication 17, dans laquelle la quantité d'anhydride cyclique s'échelonne de 1 à 15% en poids, par rapport au poids total de la composition.